# EUROPÄISCHE PATENTSCHRIFT

(11) **EP 3 313 798 B1**
(45) Veröffentlichungstag und Bekanntmachung des Hinweises auf die Patenterteilung: **20.01.2021**
(21) Anmeldenummer: 16729804.1
(22) Anmeldetag: 27.05.2016
(51) Int. Cl.: C03C 27/10, C09J 153/00, C09J 163/00, H01L 31/048, C08L 53/00, C08L 63/00, C08L 21/00, H01L 23/29, H01L 23/00, H01L 33/56, H01L 51/52

(54) **KLEBEMASSE INSBESONDERE ZUR KAPSELUNG EINER ELEKTRONISCHEN ANORDNUNG**
ADHESIVE COMPOSITION, IN PARTICULAR FOR ENCAPSULATING AN ELECTRONIC ARRANGEMENT
MASSE ADHÉSIVE, NOTAMMENT POUR L'ENCAPSULATION D'UN SYSTÈME ÉLECTRONIQUE

(30) Priorität: 29.06.2015 DE 102015212058
(43) Veröffentlichungstag der Anmeldung: 02.05.2018
(73) Patentinhaber: tesa SE, 22848 Norderstedt (DE)
(72) Erfinder: DOLLASE, Thilo, 22397 Hamburg (DE); KRAWINKEL, Thorsten, 22457 Hamburg (DE); KEITE-TELGENBÜSCHER, Klaus, 22529 Hamburg (DE); SCHUH, Christian, 22767 Hamburg (DE); GARGIULO, Jessika, 20255 Hamburg (DE)
(74) Vertreter: tesa SE
(86) Internationale Anmeldenummer: PCT/EP2016/062033
(87) Internationale Veröffentlichungsnummer: WO 2017/001126

(56) Entgegenhaltungen:
- WO-A1-2013/057265
- Anonymous: "K-PURE TAG-2678 (Product data sheet)", King Industries , 28. Mai 2011 (2011-05-28), XP002759766, Gefunden im Internet: URL:http://www.kingindustries.com/assets/1 /7/K-PURE_TAG-2678_Data_Sheet2.pdf [gefunden am 2016-07-12]

## Beschreibung

Die vorliegende Erfindung betrifft eine Klebemasse insbesondere zur Kapselung einer elektronischen Anordnung.

(Opto-)Elektronische Anordnungen werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen dieser. Diese Anordnungen und Produkte sind je nach gewünschter Anwendung starr oder flexibel ausgebildet, wobei eine zunehmende Nachfrage nach flexiblen Anordnungen besteht. Die Herstellung derartiger Anordnungen erfolgt beispielsweise durch Druckverfahren wie Hochdruck, Tiefdruck, Siebdruck, Flachdruck oder auch so genanntes "non impact printing" wie etwa Thermotransferdruck, Tintenstrahldruck oder Digitaldruck. Vielfach werden aber auch Vakuumverfahren wie zum Beispiel Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung, verwendet, wobei die Strukturierung in der Regel durch Masken erfolgt.

Als Beispiele für bereits kommerzielle oder in ihrem Marktpotential interessante (opto-) elektronische Anwendungen seien hier elektrophoretische oder elektrochrome Aufbauten oder Displays, organische oder polymere Leuchtdioden (OLEDs oder PLEDs) in Anzeige- und Display-Vorrichtungen oder als Beleuchtung genannt, Elektrolumineszenzlampen, lichtemittierende elektrochemische Zellen (LEECs), organische Solarzellen, bevorzugt Farbstoff- oder Polymersolarzellen, anorganische Solarzellen, bevorzugt Dünnschichtsolarzellen, insbesondere auf der Basis von Silizium, Germanium, Kupfer, Indium und/oder Selen, organische Feldeffekt-Transistoren, organische Schaltelemente, organische optische Verstärker, organische Laserdioden, organische oder anorganische Sensoren oder auch organisch- oder anorganisch basierte RFID-Transponder angeführt.

Als technische Herausforderung für die Realisierung einer ausreichenden Lebensdauer und Funktion von (opto-)elektronischen Anordnungen im Bereich der anorganischen und/oder organischen (Opto-)Elektronik, ganz besonders im Bereich der organischen (Opto-)Elektronik, ist ein Schutz der darin enthaltenen Komponenten vor Permeaten zu sehen. Permeate können eine Vielzahl von niedermolekularen organischen oder anorganischen Verbindungen sein, insbesondere Wasserdampf und Sauerstoff.

Eine Vielzahl von (opto-)elektronischen Anordnungen im Bereich der anorganischen und/oder organischen (Opto-)Elektronik, ganz besonders bei Verwendung von organischen Rohstoffen, ist sowohl gegen Wasserdampf als auch gegen Sauerstoff empfindlich, wobei für viele Anordnungen das Eindringen von Wasserdampf als größeres Problem eingestuft wird. Während der Lebensdauer der elektronischen Anordnung ist deshalb ein Schutz durch eine Verkapselung erforderlich, da andernfalls die Leistung über den Anwendungszeitraum nachlässt. So kann sich beispielsweise durch eine Oxidation der Bestandteile etwa bei lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Bei der anorganischen und/oder organischen (Opto-)Elektronik, insbesondere bei der organischen (Opto-)Elektronik, gibt es besonderen Bedarf für flexible Klebelösungen, die eine Permeationsbarriere für Permeate, wie Sauerstoff und/oder Wasserdampf, darstellen. Daneben gibt es eine Vielzahl von weiteren Anforderungen für derartige (opto-)elektronische Anordnungen. Die flexiblen Klebelösungen sollen daher nicht nur eine gute Haftung zwischen zwei Substraten erzielen, sondern zusätzlich Eigenschaften wie hohe Scherfestigkeit und Schälfestigkeit, chemische Beständigkeit, Alterungsbeständigkeit, hohe Transparenz, einfache Prozessierbarkeit sowie hohe Flexibilität und Biegsamkeit erfüllen.

Ein nach dem Stand der Technik gängiger Ansatz ist deshalb, die elektronische Anordnung zwischen zwei für Wasserdampf und Sauerstoff undurchlässige Substrate zu legen. Anschließend erfolgt dann eine Versiegelung an den Rändern. Für unflexible Aufbauten werden Glas oder Metallsubstrate verwendet, die eine hohe Permeationsbarriere bieten, aber sehr anfällig für mechanische Belastungen sind. Ferner verursachen diese Substrate eine relativ große Dicke der gesamten Anordnung. Im Falle von Metallsubstraten besteht zudem keine Transparenz. Für flexible Anordnungen hingegen kommen Flächensubstrate, wie transparente oder nicht transparente Folien, zum Einsatz, die mehrlagig ausgeführt sein können. Hierbei können sowohl Kombinationen aus verschiedenen Polymeren, als auch anorganische oder organische Schichten verwendet werden. Der Einsatz solcher Flächensubstrate ermöglicht einen flexiblen, äußerst dünnen Aufbau. Dabei sind für die verschiedenen Anwendungen unterschiedlichste Substrate wie zum Beispiel Folien, Gewebe, Vliese und Papiere oder Kombinationen daraus möglich.

Um eine möglichst gute Versiegelung zu erzielen, werden spezielle Barriereklebemassen verwendet. Eine gute Klebemasse für die Versiegelung von (opto-)elektronischen Bauteilen weist eine geringe Permeabilität gegen Sauerstoff und insbesondere gegen Wasserdampf auf, hat eine ausreichende Haftung auf der Anordnung und kann gut auf diese auffließen. Ein geringes Auffließvermögen auf der Anordnung kann durch unvollständige Benetzung der Oberfläche der Anordnung und durch zurückbleibende Poren die Barrierewirkung an der Grenzfläche verringern, da ein seitlicher Eintritt von Sauerstoff und Wasserdampf unabhängig von den Eigenschaften der Klebmasse ermöglicht wird. Nur wenn der Kontakt zwischen Masse und Substrat durchgängig ist, sind die Masseeigenschaften der bestimmende Faktor für die Barrierewirkung der Klebemasse.

Zur Charakterisierung der Barrierewirkung werden üblicherweise die Sauerstofftransmissionsrate OTR (Oxygen Transmission Rate) sowie die Wasserdampftransmissionsrate WVTR (Water Vapor Transmission Rate) angegeben. Die jeweilige Rate gibt dabei den flächen- und zeitbezogenen Fluss von Sauerstoff beziehungsweise Wasserdampf durch einen Film unter spezifischen Bedingungen von Temperatur und Partialdruck sowie gegebenenfalls weiterer Messbedingungen wie relativer Luftfeuchtigkeit an. Je geringer diese Werte sind, desto besser ist das jeweilige Material zur Kapselung geeignet. Die Angabe der Permeation basiert dabei nicht allein auf den Werten für WVTR oder OTR, sondern beinhaltet immer auch eine Angabe zur mittleren Weglänge der Permeation wie zum Beispiel die Dicke des Materials oder eine Normalisierung auf eine bestimmte Weglänge.

Die Permeabilität P ist ein Maß für die Durchlässigkeit eines Körpers für Gase und/oder Flüssigkeiten. Ein niedriger P-Wert kennzeichnet eine gute Barrierewirkung. Die Permeabilität P ist ein spezifischer Wert für ein definiertes Material und ein definiertes Permeat unter stationären Bedingungen bei bestimmter Permeationsweglänge, Partialdruck und Temperatur. Die Permeabilität P ist das Produkt aus Diffusions-Term D und Löslichkeits-Term S: P = D ^{∗} S

Der Löslichkeitsterm S beschreibt vorliegend die Affinität der Barriereklebemasse zum Permeat. Im Fall von Wasserdampf wird beispielsweise ein geringer Wert für S von hydrophoben Materialen erreicht. Der Diffusionsterm D ist ein Maß für die Beweglichkeit des Permeats im Barrierematerial und ist direkt abhängig von Eigenschaften, wie der Molekülbeweglichkeit oder dem freien Volumen. Oft werden bei stark vernetzten oder hochkristallinen Materialen für D relativ niedrige Werte erreicht. Hochkristalline Materialien sind jedoch in der Regel weniger transparent und eine stärkere Vernetzung führt zu einer geringeren Flexibilität. Die Permeabilität P steigt üblicherweise mit einer Erhöhung der molekularen Beweglichkeit an, etwa auch wenn die Temperatur erhöht oder der Glasübergangspunkt überschritten wird.

Ein geringer Löslichkeitsterm S ist meist unzureichend, um gute Barriereeigenschaften zu erreichen. Ein klassisches Beispiel dafür sind insbesondere Siloxan-Elastomere. Die Materialien sind äußerst hydrophob (kleiner Löslichkeitsterm), weisen aber durch ihre frei drehbare Si-O-Bindung (großer Diffusions-Term) eine vergleichsweise geringe Barrierewirkung gegen Wasserdampf und Sauerstoff auf. Für eine gute Barrierewirkung ist also eine gute Balance zwischen Löslichkeitsterm S und Diffusionsterm D notwendig.

Ansätze, um die Barrierewirkung einer Klebemasse zu erhöhen, müssen die beiden Parameter D und S insbesondere im Hinblick auf den Einfluss auf die Durchlässigkeit von Wasserdampf und Sauerstoff berücksichtigen. Zusätzlich zu diesen chemischen Eigenschaften müssen auch Auswirkungen physikalischer Einflüsse auf die Permeabilität bedacht werden, insbesondere die mittlere Permeationsweglänge und Grenzflächeneigenschaften (Auffließverhalten der Klebemasse, Haftung). Die ideale Barriereklebemasse weist geringe D-Werte und S-Werte bei sehr guter Haftung auf dem Substrat auf.

Hierfür werden bisher vor allem Flüssigklebstoffe und Adhäsive auf Basis von Epoxiden verwendet (WO 98/21287 A1; US 4,051,195 A; US 4,552,604 A). Diese haben durch eine starke Vernetzung einen geringen Diffusionsterm D. Ihr Haupteinsatzgebiet sind Randverklebungen starrer Anordnungen, aber auch mäßig flexibler Anordnungen. Eine Aushärtung erfolgt thermisch oder mittels UV-Strahlung. Eine vollflächige Verklebung ist aufgrund des durch die Aushärtung auftretenden Schrumpfes kaum möglich, da es beim Aushärten zu Spannungen zwischen Kleber und Substrat kommt, die wiederum zur Delaminierung führen können.

Der Einsatz dieser flüssigen Klebstoffe birgt eine Reihe von Nachteilen. So können niedermolekulare Bestandteile (VOC - volatile organic compound) die empfindlichen elektronischen Strukturen der Anordnung schädigen und den Umgang in der Produktion erschweren. Der Klebstoff muss aufwändig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess und auch durch den anschließend erforderlichen Laminationsschritt kann durch die geringe Viskosität das Erreichen einer definierten Schichtdicke und Verklebungsbreite in engen Grenzen erschwert sein.

Des Weiteren weisen solche hochvernetzten Klebstoffe nach dem Aushärten nur noch eine geringe Flexibilität auf. Der Einsatz von thermisch-vernetzenden Systemen wird im niedrigen Temperaturbereich oder bei 2-Komponenten-Systemen durch die Topfzeit begrenzt, also die Verarbeitungszeit bis eine Vergelung stattgefunden hat. Im hohen Temperaturbereich und insbesondere bei langen Reaktionszeiten begrenzen wiederum die empfindlichen (opto-)elektronischen Strukturen die Verwendbarkeit derartiger Systeme - die maximal anwendbaren Temperaturen bei (opto-)elektronischen Strukturen liegen oft unter 120 °C, da bei zu hohen Temperaturen eine Vorschädigung eintreten kann. Insbesondere flexible Anordnungen, die organische Elektronik enthalten und mit transparenten Polymerfolien oder Verbunden aus Polymerfolien und anorganischen Schichten gekapselt sind, setzen hier enge Grenzen. Dies gilt auch für Laminierschritte unter großem Druck. Um eine verbesserte Haltbarkeit zu erreichen, ist hier ein Verzicht auf einen temperaturbelastenden Schritt und eine Laminierung unter geringerem Druck von Vorteil.

Alternativ zu den thermisch härtbaren Flüssigklebstoffen werden mittlerweile vielfach auch strahlenhärtende Klebstoffe eingesetzt (US 2004/0225025 A1, US 2010/0137530 A1, WO 2013/057265, WO 2008/144080 A1). Die Verwendung von strahlenhärtenden Klebstoffen vermeidet eine lange andauernde Wärmebelastung der (opto-)elektronischen Anordnung.

Insbesondere wenn die (opto-)elektronischen Anordnungen flexibel sein sollen, ist es wichtig, dass der verwendete Kleber auch nach der Härtung nicht zu starr und spröde ist. Daher sind aus diesem Grund besonders Haftklebemassen und hitzeaktiviert verklebbare Klebefolien (im Gegensatz zu Flüssigklebern) im Prinzip geeignet für eine solche Verklebung. Um auf den Untergrund gut aufzufließen aber gleichzeitig eine hohe Verklebungsfestigkeit zu erzielen, sollten die Klebemassen zunächst möglichst weich sein, dann aber vernetzt werden können. Als Vernetzungsmechanismen lassen sich je nach chemischer Basis der Klebemasse Temperaturhärtungen und/oder Strahlenhärtungen durchführen. Während die Temperaturhärtung recht langsam ist, können Strahlungshärtungen innerhalb weniger Sekunden initiiert werden. Daher sind Strahlenhärtungen, insbesondere die UV-Härtung, insbesondere bei kontinuierlichen Herstellverfahren oft bevorzugt. Manche empfindliche (Opto-)Elektronik ist jedoch gegenüber der zur Härtung solcher Systeme erforderlichen UV-Strahlung sensibel.

Geeignete thermische Härtungsverfahren, die einen ausreichend geringen Temperaturbereich zur Aktivierung nutzen, bei Raumtemperatur aber kaum oder sogar keine Reaktivität zeigen, deren Reaktivsystem mit der empfindlichen (opto-)elektronischen Anordnung verträglich sind, d. h. diese nicht erkennbar schädigen und die mit wirtschaftlich akzeptablen Taktzeiten bei der Härtung auskommen, sind daher nach wie vor gesucht.

Die DE 10 2008 060 113 A1 beschreibt ein Verfahren zur Kapselung einer elektronischen Anordnung gegen Permeate, bei dem eine Haftklebemasse auf Basis von Butylenblockcopolymeren, insbesondere Isobutylenblockcopolymeren, genutzt wird, und die Verwendung einer solchen Klebemasse in einem Kapselungsverfahren. In Kombination mit den Elastomeren werden bestimmte Harze, charakterisiert durch DACP- und MMAP-Werte bevorzugt. Die Klebemasse ist zudem bevorzugt transparent und kann UVblockende Eigenschaften zeigen. Als Barriereeigenschaften weist die Klebemasse bevorzugt ein WVTR von < 40 g/m^{2*}d und ein OTR von < 5000 g/m^{2*}d bar auf. In dem Verfahren kann die Haftklebemasse während und/oder nach der Applikation erwärmt werden. Die Haftklebemasse kann vernetzt werden zum Beispiel strahlenchemisch oder thermisch. Es werden Substanzklassen vorgeschlagen, über die eine solche Vernetzung vorteilhaft ausgeführt werden kann. Jedoch werden keine konkreten Beispiele gegeben, die zu besonders geringer Volumen- und Grenzflächenpermeation bei hoher Transparenz und Flexibilität führen.

Die US 2006/100299 A1 offenbart eine Haftklebemasse, die ein Polymer mit einer Erweichungstemperatur im Sinne der US 2006/100299 A1 von größer +60 °C, ein polymerisierbares Harz mit einer Erweichungstemperatur im Sinne der US 2006/100299 A1 von kleiner +30 °C und einen latentreaktiven, insbesondere photoaktivierbaren Initiator enthält, der zu einer Reaktion zwischen Harz und Polymer führen kann. Reaktiv ausgestattete Polymere sind aber nicht universell verfügbar, so dass man bei der Auswahl dieser Polymerbasis eingeschränkt ist, wenn es um weitere Eigenschaften und Kosten geht. Zudem bringt jede Art von Funktionalisierung (über die Reaktivität geschaffen werden soll) einen Anstieg an Grundpolarität und damit eine unerwünschte Erhöhung an Wasserdampfpermeabilität. Es sind keine Copolymere basierend auf Isobutylen oder Butylen genannt, und es werden keine Angaben zu Molmassen der Polymere gemacht. Die Schrift diskutiert diverse Nachteile der thermischen Härtung für die Verkapselung von OLEDs.

Thermisch aktivierbare Klebesysteme zur Verkapselung z. B. von OLEDs sind bekannt (US 5,242,715, WO 2015/027393 A1, WO 2015/068454 A1, JP 2015/050143 A1, KR 2009-110132 A1, WO2014/199626 A1) Hier werden jedoch stets Flüssigklebesysteme beschrieben mit den entsprechenden weiter oben aufgeführten Nachteilen.

US 2014/0367670 A1 lehrt thermisch initiierte kationisch härtbare Formulierungen, die ebenfalls zur Verkapselung von OLEDs genutzt werden können. Zur Härtung von Epoxidharzen werden quaternäre Ammoniumverbindungen genannt. Als Härtungstemperaturen wird ein Bereich zwischen 70°C und 150°C, spezifischer zwischen 80°C und 110°C und noch spezifischer zwischen 90°C und 100°C angegeben. Die Formulierungen können auch in Folienform appliziert werden. Dem Reaktivsystem können Polymere zugegeben werden. Dazu werden beispielhaft Polymere mit sehr unterschiedlicher Polarität angegeben. Nicht jedoch angegeben werden Polymere mit besonders guter Barrierewirkung wie Polyisobutylen oder Polybutylen. Vielmehr wird zur Erzeugung von Barriereeigenschaften als zusätzliche Schicht eine Passivierungsschicht eingeführt. Die Kombination eines thermisch aktivierbaren Epoxidsystems mit geringer Aktivierungstemperatur und under einer Polybutylen-oder Polyisobutylen-haltigen Mattrix scheint offenbar nicht auf der Hand zu liegen oder wird als schwierig realisierbar eingeschätzt. Aufgabe der Erfindung ist es, eine vergilbungsarme Klebemasse zur Verfügung zu stellen, die den schädlichen Einfluss von Sauerstoff und Wasserdampf auf empfindliche Funktionsschichten wie zum Beispiel im Bereich von organischen Photozellen für Solarmodule oder im Bereich von organischen Licht emittierenden Dioden (OLEDs) durch eine gute Barrierewirkung gegenüber den schädlichen Substanzen unterbinden kann, die verschiedene Bauteile der Funktionselemente miteinander verbinden kann, die gut handhabbar in Verklebungsprozessen ist, die eine flexible und saubere Verarbeitung erlaubt und die trotzdem beim Hersteller einfach und wirtschaftlich zu verarbeiten ist.

Gelöst wird diese Aufgabe durch eine Klebemasse, wie sie im Hauptanspruch näher gekennzeichnet ist. In den Unteransprüchen sind vorteilhafte Ausführungsformen der Erfindung beschrieben. Des Weiteren ist die Verwendung der erfindungsgemäßen Klebemasse umfasst und ein Verbund, die durch die Verklebung mit dem erfindungsgemäßen Klebesystem erzeugt wurde.

Demgemäß betrifft die Erfindung eine Klebemasse, vorzugsweise Haftklebemasse umfassend
(a) zumindest ein (Co-)polymer enthaltend zumindest Isobutylen und/oder Butylen als Comonomersorte und, optional aber bevorzugt, zumindest eine Comonomersorte, die - als hypothetisches Homopolymer betrachtet - eine Erweichungstemperatur von größer 40 °C aufweist,
(b) zumindest eine Sorte eines zumindest teilhydrierten Klebharzes,
(c) zumindest eine Sorte eines Reaktivharzes auf Basis eines cyclischen Ethers mit einer Erweichungstemperatur von kleiner 40°C, bevorzugt von kleiner 20 °C,
(d) zumindest eine Sorte eines latentreaktiven thermisch aktivierbaren Initiators für die Initiierung einer kationischen Härtung, dadurch gekennzeichnet, dass der Initiator eine Latenz im Temperaturbereich unterhalb 60°C und eine Aktivierungstemperatur von höchstens 125°C aufweist.

Bei amorphen Stoffen entspricht die Erweichungstemperatur dabei der Glasübergangstemperatur (Test A), bei (semi)kristallinen Stoffen entspricht die Erweichungstemperatur dabei der Schmelztemperatur.

Im Bereich der Klebstoffe zeichnen sich Haftklebemassen insbesondere durch ihre permanente Klebrigkeit und Flexibilität aus. Ein Material, das permanente Haftklebrigkeit aufweist, muss zu jedem Zeitpunkt eine geeignete Kombination aus adhäsiven und kohäsiven Eigenschaften aufweisen. Für gute Haftungseigenschaften gilt es, Haftklebemassen so einzustellen, dass eine optimale Balance aus adhäsiven und kohäsiven Eigenschaften besteht.

Vorzugsweise ist die Klebemasse eine Haftklebemasse, also eine viskoelastische Masse, die bei Raumtemperatur in trockenem Zustand permanent klebrig und klebfähig bleibt. Die Klebung erfolgt durch leichten Anpressdruck sofort auf fast allen Substraten.

Das oder die (Co-)polymere sind gemäß einer bevorzugten Ausführungsform der Erfindung Homopolymere oder statistische, alternierende, Block-, Stern- und/oder Pfropfcopolymere mit einer Molmasse M_{w} (Gewichtsmittel) von 1.000.000 g/mol oder kleiner, bevorzugt 500.000 g/mol oder kleiner. Kleinere Molgewichte sind dabei aufgrund ihrer besseren Verarbeitbarkeit bevorzugt. Höhere Molgewichte, insbesondere bei Homopolymeren, führen zu gesteigerter Kohäsion der Formulierung im Klebefilm. Die Bestimmung des Molekulargewichts erfolgt über GPC (Test B).

Als Homopolymer kommt Polyisobutylen und/oder Polybutylen oder Gemische verschiedener Polyisobutylene und/oder Polybutylene z. B. in Hinblick auf ihr Molekulargewicht zum Einsatz.

Als Copolymere kommen zum Beispiel statistische Copolymere aus mindestens zwei verschiedenen Monomersorten zum Einsatz, von denen zumindest eine Isobutylen oder Butylen ist. Sehr bevorzugt kommt neben Isobutylen und/oder Butylen als zumindest eine weitere Monomersorte ein Comonomer mit einer - als hypothetisches Homopolymer betrachtet - Erweichungstemperatur von größer 40 °C zum Einsatz. Vorteilhafte Beispiele für diese zweite Comonomersorte sind Vinylaromaten (auch teil- oder vollhydrierte Varianten), Methylmethacrylat, Cyclohexylmethacrylat, Isobornylmethacrylat und Isobornylacrylat. In dieser Ausführungsform können die Molgewichte weiter reduziert werden, so dass sie günstigerweise sogar unter 200.000 g/mol liegen können.

Besonders bevorzugte Beispiele sind Styrol und α-Methylstyrol, wobei diese Aufzählung keinen Anspruch auf Vollständigkeit erhebt.

Weiter vorzugsweise sind das oder die Copolymere Block-, Stern- und/oder Pfropfcopolymere, die zumindest eine Sorte eines ersten Polymerblocks ("Weichblock") mit einer Erweichungstemperatur von kleiner -20 °C und zumindest eine Sorte eines zweiten Polymerblocks ("Hartblock") mit einer Erweichungstemperatur von größer +40 °C aufweisen.

Der Weichblock ist dabei bevorzugt unpolar aufgebaut und enthält bevorzugt Butylen oder Isobutylen als Homopolymerblock oder Copolymerblock, letztere vorzugsweise mit sich selbst oder miteinander oder mit weiteren besonders bevorzugt unpolaren Comonomeren copolymerisiert. Als unpolare Comonomere sind beispielsweise (teil-) hydriertes Polybutadien, (teil-)hydriertes Polyisopren und/oder Polyolefine geeignet.

Der Hartblock ist bevorzugt aus Vinylaromaten (auch teil- oder vollhydrierte Varianten), Methylmethacrylat, Cyclohexylmethacrylat, Isobornylmethacrylat und/oder Isobornylacrylat aufgebaut. Besonders bevorzugte Beispiele sind Styrol und α-Methylstyrol, wobei diese Aufzählung keinen Anspruch auf Vollständigkeit erhebt. Der Hartblock enthält damit die zumindest eine Comonomersorte, die - als hypothetisches Homopolymer betrachtet - eine Erweichungstemperatur von größer 40 °C aufweist.

In einer besonders vorteilhaften Ausführungsform sind die beschriebenen bevorzugten Weich- und Hartblöcke gleichzeitig in dem oder den Copolymeren verwirklicht.

Es ist vorteilhaft, wenn es sich bei dem zumindest einen Blockcopolymer um ein Triblockcopolymer handelt, das aus zwei endständigen Hartblöcken und einem mittelständige Weichblock aufgebaut ist. Diblockcopolymere sind ebenfalls gut geeignet wie auch Gemische aus Tri- und Diblockcopolymeren.

Sehr bevorzugt werden Triblockcopolymere vom Typ Polystyrol-block-Polyisobutylenblock-Polystyrol eingesetzt. Solche Systeme sind unter den Bezeichnungen SIBStar von der Firma Kaneka und Oppanol IBS von der Firma BASF bekannt gemacht worden. Weitere vorteilhaft einsetzbare Systeme sind in EP 1 743 928 A1 beschrieben.

Dadurch, dass die Copolymere einen Anteil an Isobutylen oder Butylen als zumindest eine Comonomersorte enthalten, resultiert eine unpolare Klebemasse, die vorteilhaft niedrige Volumenbarriereeigenschaften insbesondere gegenüber Wasserdampf bieten.

Die im Gegensatz zu z. B. Polyisobutylen-Homopolymeren geringen Molmassen der Copolymere erlauben eine gute Verarbeitbarkeit beim Hersteller, insbesondere in Formulierungs- und Beschichtungsprozessen. Geringe Molmasse führt zu verbesserter und schnellerer Löslichkeit, wenn Lösungsmittel basierende Prozesse gewünscht sind (besonders bei Isobutylen- und Butylen-Polymeren ist die Auswahl an geeigneten Lösungsmitteln gering). Es sind zudem höhere Copolymerkonzentrationen in der Lösung möglich. Auch in Lösungsmittel freien Prozessen zeigt sich eine erfindungsgemäß niedrige Molmasse als vorteilhaft, da die Schmelzeviskosität geringer ist als bei Vergleichssystemen mit höherer Molmasse, auch wenn diese im Sinne dieser Erfindung nicht bevorzugt werden.

Bloße Reduktion der Molmasse führt zwar naturgemäß zu besserer Löslichkeit und niedrigeren Lösungs- und Schmelzeviskositäten. Jedoch leiden mit der geringeren Molmasse andere anwendungstechnisch wichtige Eigenschaften wie zum Beispiel die Kohäsion einer Klebemasse. Hier steuert der erfinderische Einsatz der zumindest zweiten Comonomer-Sorte mit der für ein hypothetisches Homopolymer eigenen Erweichungstemperaturvon größer 40 °C effektiv entgegen.

Kommen Homopolymere wie insbesondere Polybutylen oder Polyisobutylen zum Einsatz, dann bieten sich Gemische aus Homopolymeren an bestehend aus einem Homopolymer mit höherem Molgewicht zur Einstellung der Kohäsion (hier bieten sich Molgewichte zwischen 200.000 g/mol und 1.000.000 g/mol an) und einem Homopolymer mit geringerem Molgewicht zur Einstellung des Auffließverhaltens (hier bieten sich Molmassen unterhalb 200.000 g/mol an).

Der Anteil an (Co)polymer an der Klebemasserezeptur liegt vorzugsweise bei mindestens 20 Gew.-% und höchstens 60 Gew.-%, bevorzugt bei mindestens 30 Gew.-% und höchstens 50 Gew.-%.

Über das zumindest eine (Co-)Polymer lassen sich die geforderten Barriereeigenschaften realisieren. Zudem wirkt es als Filmbildner, so dass sich die härtbare Formulierung als Klebeschicht in Klebebändern, so z. B. auch als Transferklebeband, in beliebigen Abmessungen vorkonfektionieren lässt. Ferner erhält auch die gehärtete Formulierung durch das (Co)polymer eine für viele (opto-)elektronische Verbünde gewünschte Flexibilität / Biegsamkeit.

Die erfindungsgemäße Klebemasse enthält zumindest eine Sorte eines zumindest teilhydrierten Klebharzes, vorteilhaft solche, die mit dem Copolymer beziehungsweise, sofern ein aus Hart- und Weichblöcken aufgebautes Copolymer eingesetzt wird, hauptsächlich mit dem Weichblock verträglich sind (Weichharze).

Es ist vorteilhaft, wenn dieses Klebharz eine Klebharzerweichungstemperatur (Test C) von größer 25 °C, bevorzugt größer 80 °C aufweist. Es ist darüber hinaus vorteilhaft, wenn ergänzend zumindest eine Sorte Klebharz mit einer Klebharzerweichungstemperatur von kleiner 20 °C eingesetzt wird. Hierüber kann, falls erforderlich, zum einen das klebtechnische Verhalten, zum anderen aber auch das Auffließverhalten auf dem Verklebungsuntergrund feineingestellt werden.

Als Harze können in der Haftklebemasse Kohlenwasserstoffharze, insbesondere hydrierte Polymerisate des Dicyclopentadiens, partiell, selektiv oder vollständig hydrierte Kohlenwasserstoffharze auf Basis von C₅-, C₅/C₉- oder C₉-Monomerströmen, Polyterpenharze auf Basis von α-Pinen und/oder β-Pinen und/oder δ-Limonen, hydrierte Polymerisate von bevorzugt reinen C₈- und Cg-Aromaten genutzt werden. Vorgenannte Klebharze können sowohl allein als auch im Gemisch eingesetzt werden.

Dabei können sowohl bei Raumtemperatur feste als auch flüssige Harze zum Einsatz kommen. Um eine hohe Alterungs- und UV-Stabilität zu gewährleisten, sind hydrierte Harze mit einem Hydrierungsgrad von mindestens 90 %, vorzugsweise von mindestens 95 % bevorzugt. Das Klebharz oder die Klebharze sind zumindest partiell mit den Isobutylen- oder Butylen-haltigen (Co)polymer-Segmenten verträglich.

Daher sind unpolare Harze mit einem DACP-Wert (diacetone alcohol cloud point) oberhalb von 30 °C und einem MMAP-Wert (mixed methylcylohexane aniline point) von größer 50 °C, insbesondere mit einem DACP-Wert oberhalb von 37 °C und einem MMAP-Wert größer 60 °C bevorzugt. Der DACP-Wert und der MMAP-Wert geben jeweils die Löslichkeit in einem bestimmten Lösemittel an (Test D). Durch die Auswahl dieser Bereiche wird eine besonders hohe Permeationsbarriere, insbesondere gegen Wasserdampf, erreicht. Zudem ergibt sich die gewünschte Verträglichkeit mit den Isobutylen- oder Butylen-haltigen (Co)polymer-Segmenten.

Der Anteil an Klebharz(en) in der Klebemasserezeptur liegt vorzugsweise bei mindestens 20 Gew.-% und höchstens 60 Gew.-%, bevorzugt bei mindestens 30 Gew.-% und höchstens 40 Gew.-%.

Die erfindungsgemäße Klebemasse enthält weiterhin zumindest eine Sorte eines Reaktivharzes auf Basis eines cyclischen Ethers für die thermische Vernetzung mit einer Erweichungstemperatur im ungehärteten Zustand von kleiner 40 °C, bevorzugt von kleiner 20 °C.

Bei den Reaktivharzen auf Basis cyclischer Ether handelt es sich insbesondere um Epoxide, also Verbindungen, die zumindest eine Oxiran-Gruppe tragen, oder Oxetane. Sie können aromatischer oder insbesondere aliphatischer oder cycloaliphatischer Natur sein. Einsetzbare Reaktivharze können monofunktionell, difunktionell, trifunktionell, tetrafunktionell oder höher funktionell bis zu polyfunktionell gestaltet sein, wobei sich die Funktionalität auf die cyclische Ethergruppe bezieht.

Beispiele, ohne sich einschränken zu wollen, sind 3,4-Epoxycyclohexylmethyl-3',4'-epoxycyclohexancarboxylat (EEC) und Derivate, Dicyclopendadiendioxid und Derivate, 3-Ethyl-3-oxetanmethanol und Derivate, Tetrahydrophthalsäurediglycidylester und Derivate, Hexahydrophthalsäurediglycidylester und Derivate, 1,2-Ethandioldiglycidylether und Derivate, 1,3-Propandioldiglycidylether und Derivate, 1,4-Butandioldiglycidylether und Derivate, höhere 1,n-Alkandioldiglycidylether und Derivate, Bis-[(3,4-epoxycyclohexyl)methyl]-adipat und Derivate, Vinylcyclohexyldioxid und Derivate, 1,4-Cyclohexandimethanol-bis-(3,4-epoxycyclohexancarboxylat) und Derivate, 4,5-Epoxytetrahydrophthalsäurediglycidylester und Derivate, Bis-[1-ethyl(3-oxetanyl)methyl)ether und Derivate, Pentaerythritoltetraglycidylether und Derivate, Bisphenol-A-Digylcidylether (DGEBA), hydriertes Bisphenol-A-Diglycidylether, Bisphenol-F-Diglycidylether, hydriertes Bisphenol-F-Diglycidylether, Epoxyphenol-Novolaks, hydrierte Epoxyphenol-Novolaks, Epoxycresol-Novolaks, hydrierte Epoxycresol-Novolaks, 2-(7-Oxabicyclospiro(1,3-dioxan-5,3'-(7-oxabicyclo[4.1.0]-heptan)), 1,4-Bis((2,3-epoxypropoxy)methyl)cyclohexan.

Reaktivharze können in ihrer monomeren oder auch dimeren, trimeren, usw. bis hin zu ihrer oligomeren Form eingesetzt werden.

Verbindungen nach WO 2013/156509 A2 können als Reaktivharze ebenfalls im Sinne dieser Erfindung eingesetzt werden.

Gemische von Reaktivharzen untereinander aber auch mit anderen coreaktiven Verbindungen wie Alkoholen (monofunktionell oder mehrfach funktionell) oder Vinylethern (monofunktionell oder mehrfach funktionell) sind ebenfalls möglich.

Der Anteil an Reaktivharz(en) an der Kleberezeptur liegt bei mindestens 20 Gew.-% und höchstens 50 Gew.-%, bevorzugt bei mindestens 25 Gew.-% und höchstens 40 Gew.-%.

Die Klebmasseformulierung enthält zudem zumindest eine Sorte eines latentreaktiven thermisch aktivierbaren Initiators für die kationische Härtung der Reaktivharze.

Die Auswahl geeigneter latentreaktiver thermischer Initiatoren für die kationische Härtung der Reaktivharze bezüglich der vorliegenden Aufgabe stellt eine besondere Herausforderung dar. Wie bereits ausgeführt muss die Temperatur, die zur Aktivierung des latentreaktivem thermischen Initiators erforderlich ist, in einem Bereich liegen, in dem der zu versiegelnde Gegenstand also insbesondere das empfindliche (opto-)elektronische Element noch ausreichend thermisch stabil ist. Die Aktivierungstemperatur (Test J) liegt daher bei höchstens 125 °C, bevorzugt sogar bei höchstens 100 °C. Andererseits ist eine hohe Stabilität bei üblichen Lager-/Transportbedingungen ("Latenz"), also fehlende Reaktivität in einem bestimmten Temperaturbereich gewünscht, wie z. B. unterhalb 40 °C. Ferner wird die Auswahl geeigneter Systeme dadurch erschwert, dass für viele Anwendungen hohe Anforderungen an die optische Qualität des Klebeprodukts und des verklebten Verbunds gestellt werden. Die Klebeprodukte selbst müssen daher bereits hohe optische Qualität aufweisen. Dies kann üblicherweise nur durch lösemittelbasierende Beschichtungen der Klebeformulierung erreicht werden. Der latentreaktive thermisch aktivierbare Initiatorfür die kationische Härtung muss also auch im Temperaturbereich des Trocknungsprozesses der lösemittelhaltigen Beschichtung stabil sein. Dies bedeutet Latenz (Test K) im Temperaturbereich unterhalb 60 °C, bevorzugt unterhalb 70 °C.

Eine Reihe thermisch aktivierbarer Initiatoren für die kationische Härtung von z. B. Epoxiden sind in der Vergangenheit beschrieben worden. In diesem Zusammenhang wird oft auch der Begriff (Härtungs-)katalysator statt Initiator verwendet. Eine Vielzahl gängiger Härtungssysteme für Epoxide ist jedoch im Sinne der vorliegenden Erfindung nicht geeignet. Hierzu zählen BF₃·Amin-Komplexe, Anhydride, Imidazole, Amine, DICY, Dialkylphenylacylsulfoniumsalze, Triphenylbenzylphoshoniumsalze und Amin-blockierte Phenylsulfoniumsäuren. Bei diesen Härtungssystemen wird eine zu hohe Aktivierungsenergie benötigt und/oder die Latenz im Lagerzustand des Klebesystems ist nicht ausreichend. Zudem sind die Forderungen nach hoher Transparenz, geringem Haze und geringer Vergilbungsneigung z. T. nicht realisierbar.

Im Sinne der vorliegenden Erfindung einsetzbare thermisch aktivierbare Initiatoren für eine kationische Härtung von Epoxiden sind insbesondere Pyridinium-, Ammonium-(insbesondere Anilinium-) und Sulfonium- (insbesondere Thiolanium-)-Salze sowie Lanthanoidtriflate.

Sehr vorteilhaft sind N-Benzylpyridinium-Salze und Benzylpyridinium-Salze, wobei Aromaten z. B. mit Alkyl- Alkoxy-, Halogen- oder Cyano-Gruppen substituiert sein können.

J. Polym. Sci. A, 1995, 33, 505ff, US 2014/0367670 A1, US 5,242,715, J. Polym. Sci. B, 2001, 39, 2397ff, EP 393893 A1, Macromolecules, 1990, 23, 431 ff, Macromolecules, 1991, 24, 2689, Macromol. Chem. Phys., 2001, 202, 2554ff, WO 2013/156509 A2 und JP 2014/062057 A1. nennen entsprechende Verbindungen, die im Sinne dieser Erfindung einsetzbar sind.

Von den kommerziell erhältlichen Initiatorsystemen seien als Beispiele für sehr vorteilhaft einsetzbare Verbindungen San-Aid SI 80 L, San-Aid SI 100 L, San-Aid SI 110 L der Firma Sanshin, Opton CP-66 und Opton CP-77 der Firma Adeka und K-Pure TAG 2678, K-Pure CXC 1612 und K-Pure CXC 1614 der Firma King Industries genannt.

Sehr vorteilhaft einsetzbar sind zudem Lanthanoidtriflate (Samarium-III-Triflat, Ytterbium-III-Triflat, Erbium-III-Triflat, Dysprosium-III-Triflat) sind bei Sigma Aldrich und Alfa Aesar (Lanthan-III-Triflat) erhältlich.

Zu geeigneten Anionen für die einsetzbaren Initiatoren zählen Hexafluoroantimonat, Hexafluorophosphat, Hexafluoroarsenat, Tetrafluoroborat und Tetra(pentafluorophenyl)borat. Zudem einsetzbare sind Anionen nach JP 2012-056915 A1 und EP 393893 A1.

Dem Fachmann sind weitere Systeme bekannt, die ebenfalls erfindungsgemäß einsetzbar sind. Latentreaktive thermisch aktivierbare Initiatoren für die kationische Härtung werden unkombiniert oder als Kombination von zwei oder mehreren thermisch härtbaren Initiatoren eingesetzt.

Der Anteil thermisch aktivierbarer Initiatoren für die kationische Härtung in Bezug auf die Reaktivharzeinsatzmenge liegt vorzugsweise bei mindestens 0,3 Gew.-% und höchstens 2,5 Gew.-%, bevorzugt bei mindestens 0,5 Gew.-% und höchstens 1,5 Gew.-%.

Gegenüber Photoinitiatoren und photoinitiierbaren Härtungssystemen weisen thermisch aktivierbare Initiatoren und Härtungssysteme die Vorteile auf, dass das Klebeband leichter transportier und verarbeitbar ist. Es braucht nicht auf Lichtausschluss geachtet zu werden. Ferner stellt UV-Licht, das für die Härtung des Klebeverbunds erforderlich ist, Schädigungspotenzial für manche empfindlichen (opto-)elektronischen Elemente dar.

Vorteilhaft im Sinne der vorliegenden Erfindung sind latentreaktive thermisch aktivierbare Initiatoren, die Aktivierungstemperatur von mindestens 60 °C und höchstens 125 °C, bevorzugt von mindestens 70 °C und höchstens 100 °C aufweisen, bei der eine kationische Härtung der Reaktivharze gestartet werden kann. Die Härtungsdauer kann dabei bei 15 min oder mehr und 2 h oder weniger liegen, auch wenn noch kürzere oder noch längere Härtungszeiten nicht ausgeschlossen sind.

Bevorzugt wird die Haftklebemasse erst nach der Applikation auf der elektronischen Anordnung teil- oder endvernetzt. Der Umsatz der Reaktivharzhärtung in Bezug auf die reaktiven Gruppen in den Reaktivharzmolekülen liegt typischerweise nicht bei 100 %. Er kann insbesondere zwischen 20 % und 90 % liegen oder zwischen 40 % und 80 %.

Der Klebemasse können übliche Zuschlagstoffe wie Alterungsschutzmittel (Antiozonantien, Antioxidantien, Lichtschutzmittel usw.) zugesetzt sein.

Als Additive zur Klebemasse werden typischerweise genutzt:
- Plastifizierungsmittel wie zum Beispiel Weichmacheröle oder niedermolekulare flüssige Polymere wie zum Beispiel niedermolekulare Polybutene
- primäre Antioxidantien wie zum Beispiel sterisch gehinderte Phenole
- sekundäre Antioxidantien wie zum Beispiel Phosphite oder Thioether
- Prozessstabilisatoren wie zum Beispiel C-Radikalfänger
- Lichtschutzmittel wie zum Beispiel UV-Absorber oder sterisch gehinderte Amine
- Verarbeitungshilfsmittel
- Netzadditive
- Haftvermittler
- Endblockverstärkerharze und/oder
- gegebenenfalls weitere Polymere von bevorzugt elastomerer Natur; entsprechend nutzbare Elastomere beinhalten unter anderem solche auf Basis reiner Kohlenwasserstoffe, zum Beispiel ungesättigte Polydiene wie natürliches oder synthetisch erzeugtes Polyisopren oder Polybutadien, chemisch im wesentlichen gesättigte Elastomere wie zum Beispiel gesättigte Ethylen-Propylen-Copolymere, α-Olefincopolymere, Ethylen-Propylenkautschuk, sowie chemisch funktionalisierte Kohlenwasserstoffe wie zum Beispiel halogenhaltige, acrylathaltige, allyl- oder vinyletherhaltige Polyolefine

Die Zuschlagstoffe oder Additive sind nicht zwingend, die Klebemasse funktioniert auch, ohne dass diese einzeln oder in beliebiger Kombination zugesetzt sind. Sie werden bevorzugt so ausgewählt, dass sie die Klebemasse nicht wesentlich einfärben oder eintrüben.

Füllstoffe können vorteilhaft in den erfindungsgemäßen Haftklebemassen eingesetzt werden. Bevorzugt werden als Füllstoffe der Klebmasse nanoskalige und/oder transparente Füllstoffe verwendet. Als nanoskalig wird ein Füllstoff vorliegend bezeichnet, wenn er in mindestens einer Dimension eine maximale Ausdehnung von etwa 100 nm, bevorzugt von etwa 10 nm, aufweist. Besonders bevorzugt werden solche in der Masse transparente Füllstoffe mit plättchenförmiger Kristallitstruktur und einem hohen Aspektverhältnis bei homogener Verteilung verwendet. Die Füllstoffe mit plättchenartiger Kristallitstruktur und Aspektverhältnissen weit über 100 haben in der Regel nur eine Dicke von einigen nm, die Länge beziehungsweise die Breite der Kristallite kann aber bis zu einigen µm betragen. Derartige Füllstoffe werden ebenfalls als Nanopartikel bezeichnet. Die partikuläre Ausgestaltung der Füllstoffe mit kleinen Abmessungen ist zudem besonders vorteilhaft für eine transparente Auslegung der Haftklebemasse.

Durch den Aufbau labyrinthartiger Strukturen mithilfe der zuvor beschriebenen Füllstoffe in der Klebstoffmatrix wird der Diffusionsweg von zum Beispiel Sauerstoff und Wasserdampf derartig verlängert, dass ihre Permeation durch die Klebstoffschicht hindurch vermindert wird. Zur besseren Dispergierbarkeit dieser Füllstoffe in der Bindemittelmatrix können diese Füllstoffe mit organischen Verbindungen oberflächlich modifiziert werden. Der Einsatz derartiger Füllstoffe an sich ist beispielsweise aus der US 2007/0135552 A1 sowie der WO 02/026908 A1 bekannt.

In einer weiteren vorteilhaften Ausführung der vorliegenden Erfindung werden auch Füllstoffe, die mit Sauerstoff und/oder Wasserdampf in besonderer Weise wechselwirken können, eingesetzt. In die (opto-)elektronische Anordnung eindringender Sauerstoff oder Wasserdampf wird dann an diesen Füllstoffen chemisch oder physikalisch gebunden. Diese Füllstoffe werden auch als "getter", "scavenger", "desiccants" oder "absorber" bezeichnet. Solche Füllstoffe umfassen beispielhaft, aber nicht einschränkend oxidierbare Metalle, Halide, Salze, Silicate, Oxide, Hydroxide, Sulfate, Sulfite, Carbonate von Metallen und Übergangsmetallen, Perchlorate und aktivierten Kohlenstoff, einschließlich seiner Modifikationen. Beispiele sind Cobaltchlorid, Calciumchlorid, Calciumbromid, Lithiumchlorid, Zinkchlorid, Zinkbromid, Siliciumdioxid (Silica Gel), Aluminiumoxid (aktiviertes Aluminium), Calciumsulfat, Kupfersulfat, Natriumdithionit, Natriumcarbonat, Magnesiumcarbonat, Titandioxid, Bentonit, Montmorillonit, Diatomenerde, Zeolithe und Oxide von (Erd)Alkalimetallen, wie Bariumoxid, Calciumoxid, Eisenoxid und Magesiumoxid oder auch Kohlenstoffnanoröhrchen. Des Weiteren können auch organische Absorber wie beispielsweise Polyolefin-Copolymere, Polyamid-Copolymere, PET-Copolyester oder weitere auf Hybridpolymeren basierte Absorber, die meist in Kombination mit Katalysatoren wie beispielsweise Cobalt verwendet werden eingesetzt werden. Weitere organische Absorber sind etwa schwach vernetzte Polyacrylsäure, Ascorbate, Glucose, Gallussäure oder ungesättigte Fette und Öle.

Um eine möglichst gute Wirksamkeit der Füllstoffe hinsichtlich der Barrierewirkung zu erzielen, sollte ihr Anteil nicht zu gering sein. Der Anteil beträgt vorzugsweise mindestens 5 Gew.-%, weiter bevorzugt mindestens 10 Gew.-% und ganz bevorzugt mindestens 15 Gew.-%. Typischerweise wird ein möglichst hoher Anteil von Füllstoffen eingesetzt, ohne dabei die Klebkräfte der Klebemasse zu stark herabzusetzen oder weitere Eigenschaften zu beeinträchtigen. Je nach Füllstofftyp können Füllstoffanteile von größer 40 Gew.-% bis 70 Gew.-% erreicht werden.

Des Weiteren ist eine möglichst feine Verteilung und möglichst hohe Oberfläche der Füllstoffe vorteilhaft. Dies ermöglicht einen höheren Wirkungsgrad und eine höhere Beladungskapazität und wird insbesondere mit nanoskaligen Füllstoffen erreicht.

Die Füllstoffe sind nicht zwingend, die Klebemasse funktioniert auch, ohne dass diese einzeln oder in beliebiger Kombination zugesetzt sind.

Weiter bevorzugt kommt eine Klebemasse zum Einsatz, die in bestimmten Ausführungen im sichtbaren Licht des Spektrums (Wellenlängenbereich von etwa 400 nm bis 800 nm) transparent ist. Die gewünschte Transparenz lässt sich insbesondere durch die Verwendung farbloser Klebharze und durch Einstellung der Kompatibilität von Copolymer (in mikrophasenseparierten Systemen wie Block- und Pfropfcopolymeren mit deren Weichblock) und Klebharz aber auch mit dem Reaktivharz erzielen. Reaktivharze werden für diesen Zweck vorteilhaft aus aliphatischen und cycloaliphatischen Systemen ausgewählt. Eine derartige Haftklebemasse eignet sich somit auch besonders gut für einen vollflächigen Einsatz über einer (opto-)elektronischen Struktur. Eine vollflächige Verklebung bietet, bei einer etwa mittigen Anordnung der elektronischen Struktur gegenüber einer Randversiegelung den Vorteil, dass das Permeat durch die gesamte Fläche diffundieren müsste, bevor er die Struktur erreicht. Der Permeationsweg ist somit deutlich erhöht. Die in dieser Ausführungsform verlängerten Permeationswege im Vergleich zur Randversiegelung etwa durch Flüssigklebstoffe wirken sich positiv auf die Gesamtbarriere aus, da der Permeationsweg umgekehrt proportional zur Durchlässigkeit ist.

"Transparenz" bedeutet dabei eine mittlere Transmission (Test E) der Klebemasse im sichtbaren Bereich des Lichts von mindestens 75 %, bevorzugt höher als 90 %, wobei sich diese Betrachtung auf unkorrigierte Transmission, also ohne Grenzflächenreflexionsverluste herauszurechnen, bezieht. Diese Werte beziehen sich auf die gehärtete Klebemasse.

Vorzugsweise zeigt die Klebemasse einen Haze (Test F) kleiner 5,0 %, bevorzugt kleiner 2,5 %. Diese Werte beziehen sich auf die gehärtete Klebemasse.

Für viele Anwendungen im (opto-)elektronischen Bereich ist es erforderlich, dass die Klebeformulierung kaum oder gar nicht vergilbt. Dies lässt sich über den Δb*-Wert (Test G) des CIE Lab-Systems quantifizieren. Der Δb*-Wert liegt zwischen 0 und +3,0, bevorzugt zwischen 0 und +1,5, sehr bevorzugt zwischen 0 und +1,0. Diese Werte beziehen sich auf die gehärtete Klebemasse.

Die Herstellung und Verarbeitung der Haftklebemasse erfolgt sehr bevorzugt aus Lösung. Dabei kommt ein Lösemittel(-gemisch) zu Einsatz, das sich bei einer Temperatur unterhalb der Aktivierungstemperatur des latentreaktiven thermisch aktivierbaren Initiators durch Trocknung entfernen lässt. Sehr vorteilhaft sind solche Lösemittel, auch in Gemischen, mit einem Siedepunkt bei Umgebungsdruck (hier sei Normaldruck angenommen) von höchstens 100 °C, bevorzugt von höchstens 80 °C, sehr bevorzugt von höchstens 65 °C.

Im Rahmen des Herstellverfahrens werden die Bestandteile der Haftklebemasse in einem geeigneten Lösungsmittel, zum Beispiel einem Alkan oder Cycloalkan oder Mischungen aus Alkan, Cycloalkan und Keton, gelöst und mit allgemein bekannten Verfahren auf den Träger aufgebracht. Bei Verfahren aus der Lösung sind Beschichtungen mit Rakeln, Messern, Walzen oder Düsen bekannt, um nur einige zu nennen. Dem Fachmann sind die Prozessparameter geläufig, um transparente Klebeschichten zu erhalten. In Lösungsmittelbeschichtungsprozessen kann über die Auswahl des Lösungsmittels oder des Lösungsmittelgemischs das Beschichtungsergebnis beeinflusst werden. Dem Fachmann ist auch hier geläufig, geeignete Lösungsmittel auszuwählen. Kombinationen aus insbesondere unpolaren Lösungsmitteln, die unter 100 °C sieden, mit Lösungsmitteln, die oberhalb 100 °C sieden, insbesondere aromatische, sind ebenfalls denkbar. Da die Trocknungseigenschaften von Lösemitteln nicht nur von ihrer Siedetemperatur abhängen, können im Prinzip auch Gemische mit Lösemitteln mit Siedetemperaturen oberhalb 100 °C wie z. B. Toluol eingesetzt werden, sofern ein Trocknungsprozess genutzt wird, der mit Trocknungstemperaturen unterhalb der Aktivierungstemperatur des latentreaktiven thermisch aktivierbaren Initiators für ausreichende Lösemitteleliminierung auskommt. Besonders vorteilhaft lässt sich die erfindungsgemäße Klebemasse in einem ein- oder doppelseitig klebenden Klebeband verwenden. Diese Darreichungsart erlaubt eine besonders einfache und gleichmäßige Applikation der Klebemasse.

Der allgemeine Ausdruck "Klebeband" umfasst dabei ein Trägermaterial, welches ein- oder beidseitig mit einer (Haft)klebemasse versehen ist. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge (beispielsweise in Form von Umrandungen oder Begrenzungen einer (opto- )elektronischen Anordnung), Mehrschichtanordnungen und dergleichen. Dabei sind für verschiedene Anwendungen unterschiedlichste Träger wie zum Beispiel Folien, Gewebe, Vliese und Papiere mit den Klebmassen kombinierbar. Des Weiteren umfasst der Ausdruck "Klebeband" auch so genannte "Transferklebebänder", das heißt ein Klebeband ohne Träger. Bei einem Transferklebeband ist die Klebemasse vielmehr vor der Applikation zwischen flexiblen Linern aufgebracht, die mit einer Trennschicht versehen sind und/oder anti-adhäsive Eigenschaften aufweisen. Zur Applikation wird regelmäßig zunächst ein Liner entfernt, die Klebemasse appliziert und dann der zweite Liner entfernt. Die Klebemasse kann so direkt zur Verbindung zweier Oberflächen in (opto-)elektronischen Anordnungen verwendet werden.

Es sind aber auch Klebebänder möglich, bei denen nicht mit zwei Linern sondern mit einem einzigen doppelseitig trennend ausgerüstet Liner gearbeitet wird. Die Klebebandbahn ist dann an ihrer Oberseite mit der einen Seite eines doppelseitig trennend ausgerüsteten Liners abgedeckt, ihre Unterseite mit der Rückseite des doppelseitig trennend ausgerüsteten Liners, insbesondere einer benachbarten Windung auf einem Ballen oder einer Rolle.

Als Trägermaterial eines Klebebandes werden vorliegend bevorzugt Polymerfolien, Folienverbunde oder mit organischen und/oder anorganischen Schichten versehene Folien oder Folienverbunde eingesetzt. Derartige Folien/Folienverbunde können aus allen gängigen zur Folienherstellung verwendeten Kunststoffen bestehen, beispielhaft aber nicht einschränkend erwähnt seien:
Polyethylen, Polypropylen - insbesondere das durch mono-oder biaxiale Streckung erzeugte orientierte Polypropylen (OPP), Cyclische Olefin Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES) oder Polyimid (PI).

Der Träger kann zudem mit organischen oder anorganischen Beschichtungen oder Schichten kombiniert sein. Dies kann durch übliche Verfahren wie zum Beispiel Lackieren, Drucken, Bedampfen, Sputtern, Co-Extrusion oder Lamination geschehen. Beispielhaft, aber nicht einschränkend erwähnt seien hier etwa Oxide oder Nitride des Siliziums und des Aluminiums, Indium-Zinn-Oxid (ITO) oder Sol-Gel-Beschichtungen.

Sehr gut als Trägerfolien sind auch solche aus Dünngläsern. Diese sind in Schichtdicken von weniger als 1 mm und sogar in 30 µm zum Beispiel. D 263 T der Firma Schott oder Willow Glass der Firma Corning verfügbar. Dünnglasfolien lassen sich durch Zulaminieren einer Kunststofffolie (zum Beispiel Polyester) mittels eines Transferklebebands, sofern gewünscht, weiter stabilisieren.

Bevorzugt werden als Dünngläser solche oder andersartige Trägermaterialien mit einer Dicke von 15 bis 200 µm, vorzugsweise 20 bis 100 µm, weiter vorzugsweise 25 bis 75, besonders vorzugsweise 30 bis 50 µm eingesetzt.

Vorteilhafterweise werden für Dünngläser ein Borosilikatglas wie D263 T eco der Firma Schott, ein Alkali-Erdalkali-Silikatglas oder ein Aluminoborosilikatglas wie AF 32 eco ebenfalls von der Firma Schott, eingesetzt. Ein alkalifreies Dünnglas wie AF32 eco ist vorteilhaft, weil die UV-Transmission höher ist. Ein alkalihaltiges Dünnglas wie D263 T eco ist vorteilhaft, weil der Wärmeausdehnungskoeffizient höher ist und besser mit den polymeren Bestandteilen des weiteren OLED-Aufbaus zusammenpasst. Derartige Gläser können im Down-Draw-Prozess, wie er in WO 00/41978 A1 referenziert ist, oder in Verfahren hergestellt werden, wie sie beispielsweise in der EP 1 832 558 A1 offenbart sind. In WO 00/41978 A1 sind weiterhin Verfahren offenbart, Verbunde aus Dünnglas und Polymerschichten oder -folien herzustellen.

Besonders bevorzugt sind diese Folien/Folienverbunde, insbesondere die Polymerfolien mit einer Permeationsbarriere für Sauerstoff und Wasserdampf versehen, wobei die Permeationsbarriere die Anforderungen für den Verpackungsbereich übertrifft (WVTR < 10⁻¹ g/(m²d) und OTR < 10⁻¹ cm³/(m²d bar) nach Test H).

Bei Dünnglasfolien oder Dünnglasfolienverbünden ist auf Grund der intrinsisch hohen Barriereeigenschaften des Glases eine entsprechende Beschichtung nicht erforderlich.

Dünnglasfolien oder Dünnglasfolienverbünde werden bevorzugt, wie in der Regel auch Polymerfolien, als Band von einer Rolle bereitgestellt. Entsprechende Gläser werden von der Firma Corning bereits unter der Bezeichung Willow Glass angeboten. Diese Lieferform lässt sich hervorragend mit einer bevorzugt ebenfalls bandförmig bereitgestellten Klebemasse laminieren.

Zudem können die Folien/Folienverbunde in bevorzugter Ausgestaltung transparent ausgebildet sein, damit auch der Gesamtaufbau eines derartigen Klebeartikels transparent ausgebildet ist. "Transparenz" bedeutet auch hier eine mittlere Transmission im sichtbaren Bereich des Lichts von mindestens 75 %, bevorzugt höher als 90 %.

Bei doppelseitig (selbst)klebenden Klebebändern können als obere und untere Schicht erfindungsgemäße Klebemassen gleicher oder verschiedener Art und/oder gleicher oder verschiedener Schichtdicke zur Anwendung kommen. Der Träger kann dabei auf einer oder beiden Seiten dem Stand der Technik entsprechend vorbehandelt sein, so dass beispielsweise eine Verbesserung der Klebemassenverankerung erzielt wird. Ebenso können eine oder beide Seiten mit einer funktionalen Schicht ausgerüstet sein, die beispielsweise als Sperrschicht fungieren kann. Die Haftklebemasseschichten können optional mit Trennpapieren oder Trennfolien eingedeckt werden. Alternativ kann auch nur eine Klebemasseschicht mit einem doppelseitig trennenden Liner eingedeckt sein.
In einer Variante ist in dem doppelseitig (selbst)klebenden Klebeband eine erfindungsgemäße Klebemasse vorgesehen sowie eine beliebige weitere, zum Beispiel eine solche, die besonders gut auf einem Abdecksubstrat haftet oder eine besonders gute Repositionierbarkeit zeigt.

Des Weiteren sind die Klebemasse sowie ein eventuell damit gebildetes Klebeband hervorragend zur Kapselung einer elektronischen Anordnung gegen Permeate geeignet, indem die Klebemasse oder das Klebeband auf und/oder um die zu kapselnden Bereiche der elektronischen Anordnung appliziert werden.

Als Kapselung wird vorliegend nicht nur ein vollumfänglicher Einschluss mit der genannten Haftklebemasse bezeichnet sondern auch bereits eine bereichsweise Applikation der Haftklebemasse auf den zu kapselnden Bereichen der (opto-) elektronischen Anordnung, beispielsweise eine einseitige Überdeckung oder eine Umrahmung einer elektronischen Struktur.

Im Prinzip können mit Klebebändern zwei Arten der Verkapselung durchgeführt werden. Entweder wird das Klebeband zuvor ausgestanzt und nur um die zu kapselnden Bereiche herum verklebt, oder es wird vollflächig über die zu kapselnden Bereiche geklebt. Ein Vorteil der zweiten Variante ist die einfachere Handhabung und der häufig bessere Schutz.

Die vorliegende Erfindung beruht zunächst auf der Erkenntnis, dass es trotz der zuvor beschriebenen Nachteile möglich ist, eine (Haft-)Klebemasse zur Kapselung einer elektronischen Anordnung zu verwenden, bei der die zuvor bezüglich Haftklebemassen beschriebenen Nachteile nicht oder nur vermindert auftreten. Es hat sich nämlich gezeigt, dass eine Klebemasse basierend auf einem (Co-)polymer enthaltend zumindest Isobutylen oder Butylen als Comonomersorte und optional aber bevorzugt zumindest eine Comonomersorte, die - als hypothetisches Homopolymer betrachtet - eine Erweichungstemperatur von größer 40 °C aufweist, zur Kapselung elektronischer Anordnungen besonders geeignet ist.
Da es sich bei der Klebemasse vorzugsweise um eine Haftklebemasse handelt, ist die Applikation besonders einfach, da keine Vorfixierung erfolgen muss. Die Haftklebemassen erlauben eine flexible und saubere Verarbeitung. Auch kann durch die Darreichung als Haftklebeband die Menge der Haftklebemasse einfach dosiert werden, und es fallen auch keine Lösemittelemissionen an. Zumindest nach der Applikation auf das Zielsubstrat oder die Zielsubstrate wird die Haftklebemasse durch thermische Aktivierung des latentreaktiven Initiators einer Vernetzung ausgesetzt. Dieser Prozessablauf wird auch bevorzugt.

Vorteil der hier vorliegenden Erfindung ist also, im Vergleich zu anderen Haftklebemassen, die Kombination aus sehr guten Barriereeigenschaften gegenüber Sauerstoff und vor allem gegenüber Wasserdampf bei gleichzeitiger guter Grenzflächenhaftung auf unterschiedlichen Substraten, guten kohäsiven Eigenschaften und, im Vergleich zu Flüssigklebstoffen, eine sehr hohe Flexibilität und eine einfache Applikation in der (optoelektronischen Anordnung und bei/in der Kapselung. Des Weiteren liegen in bestimmten Ausführungen auch hochtransparente Klebemassen vor, die in besonderer Weise für den Einsatz in (opto-)elektronischen Anordnungen Anwendung finden können, da eine Verminderung von einfallendem oder austretendem Licht sehr gering gehalten wird.

Eine Verkapselung durch Lamination von zumindest Teilen der (opto-)elektronischen Aufbauten mit einem flächigen Barrierematerial (zum Beispiel Glas, insbesondere Dünnglas, metalloxidbeschichteten Folien, Metallfolien, Multilayer-Substratmaterialien) ist mit sehr guter Barrierewirkung in einem einfachen Rolle-zu-Rolle Prozess möglich. Die Flexibilität des gesamten Aufbaus hängt, neben der Flexibilität der Haftklebemasse von weiteren Faktoren, wie Geometrie und Dicke der (opto-)elektronischen Aufbauten beziehungsweise der flächigen Barrierematerialien ab. Die hohe Flexibilität der Haftklebemasse ermöglicht es aber sehr dünne, biegsame und flexible (opto-)elektronische Aufbauten zu realisieren.

Zusammengefasst erfüllt die erfindungsgemäße Klebemasse alle Anforderungen, wie sie an eine Klebemasse gestellt werden, die zur Verkapselung einer (opto-)elektronischen Anordnung eingesetzt wird:
- eine geringe Volumenpermeation von Wasserdampf und Sauerstoff im gehärteten Zustand, was sich in einem Wert für WVTR (Mocon) von kleiner 12 g/m² d, und einem Wert für OTR (Mocon) von kleiner 1000 cm³/m²*d*bar zeigt,
- optional, aber bevorzugt hohe Transparenz mit einer Transmission von bevorzugt über 90 %
- optional, aber bevorzugt ein Haze kleiner 5,0 % bevorzugt kleiner 2,5 %
- einen Δb*-Wert zwischen 0 und +3,0, bevorzugt zwischen 0 und +1,5, sehr bevorzugt zwischen 0 und +1,0
- hohe Klebkraft für das gehärtete System auf Glas von größer 1,5 N/cm², bevorzugt größer 2,5 N/cm² (Test I).

Weitere Einzelheiten, Ziele, Merkmale und Vorteile der vorliegenden Erfindung werden nachfolgend anhand mehrerer, bevorzugte Ausführungsbeispiele darstellende Figuren näher erläutert. Es zeigen
- Fig. 1: eine erste (opto-)elektronische Anordnung in schematischer Darstellung,
- Fig. 2: eine zweite (opto-)elektronische Anordnung in schematischer Darstellung,
- Fig. 3: eine dritte (opto-)elektronische Anordnung in schematischer Darstellung.

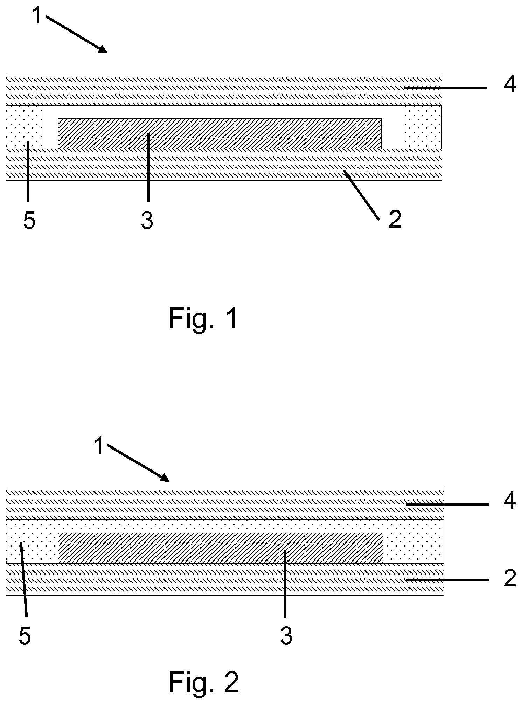

Fig. 1 zeigt eine erste Ausgestaltung einer (opto-)elektronischen Anordnung 1. Diese Anordnung 1 weist ein Substrat 2 auf, auf dem eine elektronische Struktur 3 angeordnet ist. Das Substrat 2 selbst ist als Barriere für Permeate ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.

Um die elektronische Struktur 3 auch zur Seite hin zu kapseln und gleichzeitig die Abdeckung 4 mit der elektronischen Anordnung 1 im Übrigen zu verbinden, ist eine Haftklebemasse 5 umlaufend neben der elektronischen Struktur 3 auf dem Substrat 2 vorgesehen. In anderen Ausführungsformen erfolgt die Kapselung nicht mit einer reinen Haftklebemasse 5, sondern mit einem Klebeband 5, das zumindest eine erfindungsgemäße Haftklebemasse enthält. Die Haftklebemasse 5 verbindet die Abdeckung 4 mit dem Substrat 2. Durch eine entsprechend dicke Ausgestaltung ermöglicht die Haftklebemasse 5 zudem die Beabstandung der Abdeckung 4 von der elektronischen Struktur 3.

Bei der Haftklebemasse 5 handelt es sich um eine solche auf Basis der erfindungsgemäßen Haftklebemasse wie sie vorstehend in allgemeiner Form beschrieben wurde und nachfolgend in Ausführungsbeispielen näher dargelegt ist. Die Haftklebemasse 5 übernimmt vorliegend nicht nur die Funktion des Verbindens des Substrats 2 mit der Abdeckung 4 sondern bildet zudem auch eine Barriereschicht für Permeate bereit, um so die elektronische Struktur 3 auch von der Seite gegen Permeate wie Wasserdampf und Sauerstoff zu kapseln.

Die Haftklebemasse 5 wird vorliegend zudem in Form eines Stanzlings aus einem doppelseitigen Klebebandes bereitgestellt. Ein derartiger Stanzling ermöglicht eine besonders einfache Applikation.

Fig. 2 zeigt eine alternative Ausgestaltung einer (opto-)elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun die Haftklebemasse 5 vollflächig angeordnet. Die elektronische Struktur 3 wird somit von oben vollständig durch die Haftklebemasse 5 gekapselt. Auf die Haftklebemasse 5 ist sodann eine Abdeckung 4 aufgebracht. Diese Abdeckung 4 muss im Gegensatz zu der vorherigen Ausgestaltung nicht zwingend die hohen Barriereanforderungen erfüllen, da die Barriere bereits durch die Haftklebemasse bereitgestellt wird. Die Abdeckung 4 kann beispielsweise lediglich eine mechanische Schutzfunktion wahrnehmen, sie kann aber auch zusätzlich als Permeationsbarriere vorgesehen sein.

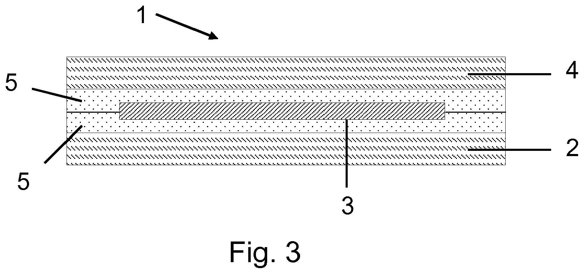

Fig. 3 zeigt eine weitere alternative Ausgestaltung einer (opto-)elektronischen Anordnung 1. Im Gegensatz zu den vorherigen Ausgestaltungen sind nun zwei Haftklebemassen 5a, 5b vorgesehen, die vorliegend identisch ausgebildet sind. Die erste Haftklebemasse 5a ist vollflächig auf dem Substrat 2 angeordnet. Auf der Haftklebemasse 5a ist die elektronische Struktur 3 vorgesehen, die durch die Haftklebemasse 5a fixiert wird. Der Verbund aus Haftklebemasse 5a und elektronischer Struktur 3 wird dann mit der weiteren Haftklebemasse 5b vollflächig überdeckt, so dass die elektronische Struktur 3 von allen Seiten durch die Haftklebemassen 5a, b gekapselt ist. Oberhalb der Haftklebemasse 5b ist wiederum die Abdeckung 4 vorgesehen.

In dieser Ausgestaltung müssen somit weder das Substrat 2 noch die Abdeckung 4 zwingend Barriereeigenschaften aufweisen. Sie können aber dennoch vorgesehen sein, um die Permeation von Permeaten zur elektronischen Struktur 3 weiter einzuschränken.

Insbesondere im Hinblick auf die Fig. 2, 3 wird darauf hingewiesen, dass es sich vorliegend um schematische Darstellungen handelt. Aus den Darstellungen ist insbesondere nicht ersichtlich, dass die Haftklebemasse 5 hier und vorzugsweise jeweils mit einer homogenen Schichtdicke aufgetragen wird. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Gegebenenfalls kann jedoch auch eine Anpassung an den Untergrund erfolgen, insbesondere dann, wenn die Applikation unter Vakuum oder unter erhöhtem Druck durchgeführt wird. Zudem wird die Haftklebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 µm dick).

Die Applikation der Haftklebemasse 5 erfolgt in allen gezeigten Ausführungsbeispielen in Form eines Haftklebebandes. Dabei kann es sich grundsätzlich um ein doppelseitiges Haftklebeband mit einem Träger oder um ein Transferklebeband handeln. Vorliegend ist eine Ausgestaltung als Transferklebeband gewählt.

Die Dicke der Haftklebemasse, die entweder als Transferklebeband oder auf einem flächigen Gebilde beschichtet vorliegt, beträgt bevorzugt zwischen etwa 1 µm und etwa 150 µm, weiter bevorzugt zwischen etwa 5 µm und etwa 75 µm und besonders bevorzugt zwischen etwa 12 µm und 50 µm. Hohe Schichtdicken zwischen 50 µm und 150 µm werden dann eingesetzt wenn eine verbesserte Haftung auf dem Substrat und/oder eine dämpfende Wirkung innerhalb des (opto-)elektronischen Aufbaus erreicht werden soll. Nachteilig ist hier jedoch der erhöhte Permeationsquerschnitt. Geringe Schichtdicken zwischen 1 µm und 12 µm reduzieren den Permeationsquerschnitt, damit die laterale Permeation und die Gesamtdicke des (opto-)elektronischen Aufbaus. Jedoch kommt es zu einer Verringerung der Haftung auf dem Substrat. In den besonders bevorzugten Dickenbereichen liegt ein guter Kompromiss zwischen einer geringen Massendicke und dem daraus folgenden niedrigen Permeationsquerschnitt, der die laterale Permeation verringert, und einem genügend dicken Massefilm zur Herstellung einer ausreichend haftenden Verbindung. Die optimale Dicke hängt vom (opto-)elektronischen Aufbau, der Endanwendung, der Art der Ausführung der Haftklebemasse und gegebenenfalls dem flächigen Substrat ab.

Für doppelseitige Klebebänder gilt für die Barriereklebemasse(n) ebenfalls, dass die Dicke der einzelnen Haftklebemasseschicht(en) bevorzugt zwischen etwa 1 µm und etwa 150 µm, weiter bevorzugt zwischen etwa 5 µm und etwa 75 µm und besonders bevorzugt zwischen etwa 12 µm und 50 µm liegt. Kommt in doppelseitigen Klebebändern neben der einen erfindungsgemäßen Barriereklebemasse eine weitere zum Einsatz, dann kann es auch vorteilhaft sein, wenn ihre Dicke oberhalb 150 µm liegt.

Ein geeignetes Verfahren zur Verklebung der Klebeprodukte mit den erfindungsgemäßen Haftklebemassen beinhaltet die Befreiung der ersten Klebeoberfläche von einer Schutzlinerschicht und der Lamination des Klebeprodukts auf ein erstes Zielsubstrat. Dies kann durch Kaschierung mittels (Gummi-)walzen oder auch in Pressen erfolgen. Durch die Haftklebrigkeit ist ein besonders hoher Druck beim Laminieren nicht in jedem Fall erforderlich. Man erhält einen Vorverbund. Anschließend wird auch die zweite Klebeoberfläche von der Schutzlinerschicht befreit und auf das zweite Zielsubstrat gebracht. Auch dies kann durch Kaschierung mittels (Gummi-)walzen oder auch in Pressen erfolgen. Die Auswahl des Laminierprozesses richtet sich dabei nach der Beschaffenheit des Vorverbunds (starr oder flexibel) und des zweiten Zielsubstrats (starr oder flexibel). Auch hier ist ein besonders hoher Druck beim Laminieren durch die Haftklebrigkeit nicht in jedem Fall erforderlich. Um den Verbund zur Aushärtung zu bringen, muss zu einem Zeitpunkt, bevorzugt während und/oder nach dem im oben angegebenen Ablauf zweiten Laminierschritt, Wärme eingebracht werden. Dies kann durch Nutzung einer Heizpresse, die bei der Lamination genutzt wird, erfolgen oder durch einen Wärmekanal, der z. B. mit einer IR-Strecke ausgestattet ist. Besonders geeignet sind auch Wärmekammern und Autoklaven. Letztere insbesondere, wenn der Verbund noch mit Druck beaufschlagt werden soll, um die Laminatqualität final zu optimieren. Bei der Wärmezuführung ist darauf zu achten, dass die Temperatur ausreicht, um den latentreaktiven thermisch aktivierbaren Initiator zu aktivieren, dass aber empfindliche Bauteilelemente nicht thermisch geschädigt werden. Die Härtungstemperaturen im Verbund liegen daher zwischen 60 °C und 125 °C, in vielen Fällen werden Temperaturen zwischen 70 °C und 100 °C bevorzugt. Auch wenn die Dauer des Wärmeeintrags auch vom Verbunddesign und den entsprechenden Wärmeübergängen abhängt, können Wärmeeintragsdauern bei bis zu 60 min liegen oder sogar darüber. Häufig werden kurze Taktzeiten gewünscht oder inline-Verfahren genutzt. Hier sind kurze Wärmeeintragsdauern erforderlich, die auch deutlich unterhalb 60 min liegen können wie z. B. auch im Bereich weiniger Minuten oder sogar darunter.

Im Folgenden wird die Erfindung durch einige Beispiele näher erläutert, ohne die Erfindung damit einschränken zu wollen.

### Prüfmethoden

### Test A - Erweichungstemperatur

Die Erweichungstemperatur von Copolymeren, Hart- und Weichblöcken und ungehärteten Reaktivharzen wird kalorimetrisch über die Differential Scanning Calorimetry (DSC) nach DIN 53765:1994-03 bestimmt. Aufheizkurven laufen mit einer Heizrate von 10 K/min. Die Muster werden in Al-Tiegeln mit gelochtem Deckel und Stickstoffatmosphäre vermessen. Es wird die zweite Aufheizkurve ausgewertet. Bei amorphen Stoffen treten Glasübergangstemperaturen auf, bei (semi)kristallinen Stoffen Schmelztemperaturen. Ein Glasübergang ist als Stufe im Thermogramm erkennbar. Die Glasübergangstemperatur wird als Mittelpunkt dieser Stufe ausgewertet. Eine Schmelztemperatur ist als Peak im Thermogramm erkennbar. Als Schmelztemperatur wird diejenige Temperatur notiert, bei der die höchste Wärmetönung auftritt.

### Test B - Molekulargewicht

Die Bestimmung des mittleren Molekulargewichtes M_{w} (Gewichtsmittel) - auch Molmasse genannt - erfolgt mittels Gelpermeationschromatographie (GPC). Als Eluent wird THF mit 0,1 Vol.-% Trifluoressigsäure eingesetzt. Die Messung erfolgt bei 25 °C. Als Vorsäule wird PSS-SDV, 5 µm, 10³ Å, ID 8,0 mm x 50 mm verwendet. Zur Auftrennung wurden die Säulen PSS-SDV, 5 µm, 10³ Å, 10⁵ Å und 10⁶ Å mit jeweils ID 8,0 mm x 300 mm eingesetzt. Die Probenkonzentration beträgt 4 g/l, die Durchflussmenge 1,0 ml pro Minute. Es wird gegen PS-Standards gemessen.

### Test C - Klebharzerweichungstemperatur

Die Klebharzerweichungstemperatur wird nach der einschlägigen Methodik durchgeführt, die als Ring and Ball bekannt ist und nach ASTM E28 standardisiert ist.

Zur Bestimmung der Klebharzerweichungstemperatur der Harze kommt ein Ring-Kugel-Automat HRB 754 der Firma Herzog zum Einsatz. Harzmuster werden zunächst fein gemörsert. Das resultierende Pulver wird in einen Messingzylinder mit Bodenöffnung (Innendurchmesser am oberen Teil des Zylinders 20 mm, Durchmesser der Bodenöffnung des Zylinders 16 mm, Höhe des Zylinders 6 mm) gefüllt und auf einem Heiztisch geschmolzen. Die Befüllmenge wird so gewählt, dass das Harz nach dem Schmelzen den Zylinder ohne Überstand voll ausfüllt.

Der resultierende Probekörper wird samt Zylinder in die Probehalterung des HRB 754 eingelegt. Zur Befüllung des Temperierbads wird Glycerin verwendet, sofern die Klebharzerweichungstemperatur zwischen 50 °C und 150 °C liegt. Bei niedrigeren Klebharzerweichungstemperaturen kann auch mit einem Wasserbad gearbeitet werden. Die Prüfkugeln haben einen Durchmesser von 9,5 mm und wiegen 3,5 g. Entsprechend der HRB 754 Prozedur wird die Kugel oberhalb des Probekörpers im Temperierbad angeordnet und auf dem Probekörper abgelegt. 25 mm unter dem Zylinderboden befindet sich eine Auffangplatte, 2 mm über dieser eine Lichtschranke. Während des Messvorgangs wird die Temperatur mit 5 °C/min erhöht. Im Temperaturbereich der Klebharzerweichungstemperatur beginnt sich die Kugel durch die Bodenöffnung des Zylinders zu bewegen, bis sie schließlich auf der Auffangplatte zum Stehen kommt. In dieser Position wird sie von der Lichtschranke detektiert und zu diesem Zeitpunkt die Temperatur des Temperierbads registriert. Es findet eine Doppelbestimmung statt. Die Klebharzerweichungstemperatur ist der Mittelwert aus den beiden Einzelmessungen.

### Test D - Harzkompatibilität

MMAP ist der gemischte-Methylcyclohexan-Anilin-Trübungspunkt, der unter Verwendung eines modifizierten ASTM C 611-Verfahrens bestimmt wird. Methylcyclohexan ist für das in dem Standard-Prüfverfahren verwendete Heptan eingesetzt. Das Verfahren verwendet Harz/Anilin/Methylcyclohexan in einem Verhältnis von 1/2/1 (5 g/10 ml/5 ml) und der Trübungspunkt wird durch Abkühlen einer erhitzten, klaren Mischung der drei Komponenten, bis die vollständige Trübung gerade eintritt, bestimmt

Der DACP ist der Diaceton-Trübungspunkt und wird durch Abkühlen einer erhitzten Lösung von 5 g Harz, 5 g Xylol und 5 g Diacetonalkohol bis zu dem Punkt bestimmt, bei welchem die Lösung trübe wird.

Zur Bestimmung von DACP- und MMAP-Werten wird auf C. Donker, PSTC Annual Technical Seminar Proceedings, Mai 2001, S. 149 - 164 hingewiesen.

### Test E - Transmission

Die Transmission der Klebemasse wurde über das VIS-Spektrum bestimmt. Die Aufnahmen des VIS-Spektrums wurden an einem UVIKON 923 der Firma Kontron durchgeführt. Der Wellenlängenbereich des gemessenen Spektrums umfasst alle Wellenlängen zwischen 800 nm und 400 nm bei einer Auflösung von 1 nm. Es wurde eine Leerkanalmessung als Referenz über den gesamten Wellenlängenbereich durchgeführt. Für die Angabe des Ergebnisses wurden die Transmissionsmessungen im angegebenen Bereich gemittelt. Eine Korrektur von Grenzflächenreflextionsverlusten wird nicht vorgenommen.

### Test F - HAZE-Messung

Der HAZE-Wert beschreibt den Anteil des transmittierten Lichts, der von der durchstrahlten Probe nach vorne großwinklig gestreut wird. Somit quantifiziert der HAZE-Wert Materialfehler in der Oberfläche oder der Struktur, die die klare Durchsicht stören.

Das Verfahren zur Messung des Haze-Wertes wird in der Norm ASTM D 1003 beschrieben. Die Norm erfordert die Messung von vier Transmissionsmessungen. Für jede Transmissionsmessung wird der Lichttransmissionsgrad berechnet. Die vier Transmissionsgrade werden zum prozentualen Haze-Wert verrechnet. Der HAZE-Wert wird mit einem Haze-gard Dual von Byk-Gardner GmbH gemessen.

### Test G - Farbwert Δb*

Es wird gemäß DIN 6174 vorgegangen, und die Farbcharakteristik im dreidimensionalen Raum, aufgespannt durch die drei Farbparameter L*, a* und b*, nach CIELab untersucht. Dazu wird ein BYK Gardner spectro-guide Messgerät verwendet, ausgestattet mit einer D/65° Lampe. Innerhalb des CIELab-Systems gibt L* den Grauwert, a* die Farbachse von grün nach rot und b* die Farbachse von blau nach gelb an. Der positive Wertebereich für b* gibt die Intensität des gelben Farbanteil an. Als Referenz diente eine weiße Keramikfliese mit einem b* von 1,80. Diese Fliese dient zudem als Probenhalter, auf den die zu prüfende Klebschicht auflaminiert wird. Die Farbmessung erfolgt an der jeweiligen reinen Klebschicht in 50 µm Schichtdicke, nachdem diese von den Trennlinern befreit worden ist. Δb* ist die Differenz aus der Farbwertbestimmung für das Klebefilmmuster appliziert auf der Substratfliese und der Farbwertbestimmung der reinen Substratfliese.

### Test H - Permeabilität für Sauerstoff (OTR) und Wasserdampf (WVTR)

Die Bestimmung der Permeabilität für Sauerstoff (OTR) und Wasserdampf (WVTR) erfolgt nach DIN 53380 Teil 3 beziehungsweise ASTM F-1249. Die Haftklebemasse wird dazu mit einer Schichtdicke von 50 µm auf eine permeable Membran aufgebracht. Die Sauerstoffdurchlässigkeit wird bei 23 °C und einer relativen Feuchte von 50 % gemessen mit einem Messgerät Mocon OX-Tran 2/21. Die Wasserdampfdurchlässigkeit wird bei 37,5 °C und einer relativen Feuchte von 90 % bestimmt.

### Test I - Klebkraft

Die Bestimmung der Klebkraft wurde wie folgt durchgeführt: Als definierter Haftgrund wurden Glasplatten (Floatglas) eingesetzt. Das zu untersuchende verklebbare Flächenelement, das rückseitig mit einer 50 µm Aluminiumfolie zur Stabilisierung versehen war, wurde auf eine Breite von 20 mm und eine Länge von etwa 25 cm zugeschnitten, mit einem Handhabungsabschnitt versehen und unmittelbar danach fünfmal mit einer Stahlrolle von 4 kg bei einem Vorschub von 10 m/min auf den jeweils gewählten Haftgrund aufgedrückt. Unmittelbar im Anschluss daran wurde das zuvor verklebte Flächenelement in einem Winkel von 180° bei Raumtemperatur und mit 300 mm/min vom Haftgrund mit einem Zugprüfungsgerät (Firma Zwick) abgezogen und die hierfür benötigte Kraft gemessen. Der Messwert (in N/cm) ergab sich als Mittelwert aus drei Einzelmessungen. Die Prüfung erfolgte an vernetzten Mustern.

### Test J - Aktivierungstemperatur

Die für die thermische Härtung der kationisch härtbaren Reaktivharze erforderliche Aktivierungstemperatur wird über Differential Scanning Calorimetry (DSC) bestimmt. Die Muster werden in Al-Tiegeln mit gelochtem Deckel und Stickstoffatmosphäre vermessen. Um ein gutes Bedecken des Tiegelbodens mit der Probe zu erreichen, wird das Muster im Gerät zunächst auf 40 °C aufgeheizt und wieder auf 25 °C abgekühlt. Die eigentliche Messung wird bei 25 °C gestartet, die Aufheizkurve läuft mit einer Heizrate von 10 K/min. Die erste Aufheizkurve wird ausgewertet. Das Anspringen der thermisch initiierten Härtungsreaktion wird von der Messapparatur durch die damit verbundene frei werdende Reaktionsenthalpie registriert und als exothermes Signal (Peak) im Thermogramm angezeigt. Als Aktivierungstemperatur wird diejenige Temperatur dieses Signals verwendet, bei der die Messkurve von der Basislinie abzuweichen beginnt (als ein Hilfsmittel, um diesen Punkt zu finden, kann die erste Ableitung des Thermogramms dienen; der Beginn der Reaktion kann mit dem Punkt im Thermogramm in Verbindung gebracht werden, bei dem die erste Ableitung des Thermogramms einen Betrag von 0,01 mW/(K min) annimmt; sind exotherme Signal im Diagramm noch oben dargestellt, dann ist das Vorzeichen positiv, sind sie nach unten dargestellt, dann ist das Vorzeichen negativ). Es wird zudem das Integral, normiert auf die eingewogene Mustermenge, notiert.

### Test K - Latenz

Die Latenz des thermisch aktivierbaren kationisch härtbaren Klebefilms, also die im Wesentlichen noch nicht einsetzende Härtungsreaktion in einem bestimmten Temperaturbereich unterhalb der gewünschten Aktivierungstemperatur wird mittels Differential Scanning Calorimetry (DSC) geprüft. Die Muster werden dazu speziell vorbereitet. Ein aus Lösung (Zusammensetzung siehe Beispiele) erzeugter Klebefilmausstrich wird im Umlufttrockenschrank bei 40 °C für 6 h getrocknet Die Schichtdicke des getrockneten Films betrug 50 µm. Die so getrockneten Muster werden in Al-Tiegeln mit gelochtem Deckel und Stickstoffatmosphäre vermessen. Um ein gutes Bedecken des Tiegelbodens mit der Probe zu erreichen, wird das Muster im Gerät zunächst auf 40 °C aufgeheizt und wieder auf 25 °C abgekühlt. Die eigentliche Messung wird bei 25 °C gestartet, die Aufheizkurve läuft mit einer Heizrate von 10 K/min bis zur gewünschten Temperatur, bei der die Härtungsreaktion im Wesentlichen noch nicht einsetzen soll, also entsprechend der obigen Ausführungen bei 60 °C bzw. 70 °C. Sobald diese Temperatur erreicht ist, wird die Probe für 5 min bei dieser Temperatur belassen, anschließend auf 25 °C abgekühlt (als Kühlrate wird -10 K/min eingestellt). Das Muster wird bei 25 °C für 5 min belassen bevor es einer zweiten Aufheizrampe (Heizrate 10 K/min) unterworfen wird. Es wird bis 200 °C aufgeheizt und das exotherme Signal analysiert, das mit dem Ablauf der Härtungsreaktion korreliert ist. Es wird die Aktivierungstemperatur (siehe Test J), und das Integral, normiert auf die eingewogene Mustermenge, dieses Signals notiert. Es werden die Ergebnisse eines Musterabschnitts, das gemäß Test K untersucht wurde, mit den Ergebnissen eines weiteren Abschnitts dieses Musters, das nicht Test K sondern Test J unterworfen war, verglichen. Das thermisch aktivierbare kationisch härtbare System wird im Sinne dieser Erfindung als latent bei der untersuchten Temperatur eingestuft, wenn das normierte Integral nach Test J (entspricht 100 % Reaktivität) um höchstens 10 %, bevorzugt um höchstens 5 % niedriger als das normierte Integral nach Test K ist und die Aktivierungstemperatur nach Test J von derjenigen aus Test K um höchstens 5 K, bevorzugt höchstens 2 K abweicht.

### Test L - Bestimmung der Durchbruchzeit (Lebensdauertest)

Als ein Maß für die Bestimmung der Lebensdauer eines elektronischen Aufbaus wurde ein Calciumtest herangezogen. Dazu wird im Vakuum eine 10 x 10 mm² große, dünne Calciumschicht auf eine Glasplatte abgeschieden und danach unter Stickstoffatmosphäre gelagert. Die Dicke der Calciumschicht liegt bei etwa 100 nm. Für die Verkapselung der Calciumschicht wird ein Klebeband (23 x 23 mm²) mit der zu testenden Klebemasse sowie einer Dünnglasscheibe (35 µm, Firma Schott) als Trägermaterial verwendet. Zur Stabilisierung war die Dünnglasscheibe mit einer 100 µm dicken PET-Folie mittels eines 50 µm dicken Transferklebebands einer optisch hochtransparenten Acrylathaftklebemasse laminiert. Die Klebemasse wird so auf der Glasplatte appliziert, dass die Klebemasse den Calciumspiegel mit einem allseitig überstehenden Rand von 6,5 mm (A-A) abdeckt. Aufgrund des undurchlässigen Glasträgers wird nur die Permeation durch den Haftkleber oder entlang der Grenzflächen ermittelt.

Der Test basiert auf der Reaktion von Calcium mit Wasserdampf und Sauerstoff, wie sie beispielsweise von A.G. Erlat et. al. in "47th Annual Technical Conference Proceedings-Society of Vacuum Coaters", 2004, Seiten 654 bis 659, und von M. E. Gross et al. in "46th Annual Technical Conference Proceedings-Society of Vacuum Coaters", 2003, Seiten 89 bis 92, beschrieben sind. Dabei wird die Lichttransmission der Calciumschicht überwacht, welche durch die Umwandlung in Calciumhydroxid und Calciumoxid zunimmt. Diese erfolgt beim beschriebenen Prüfaufbau vom Rand her, so dass sich die sichtbare Fläche des Calciumspiegels verringert. Es wird die Zeit bis zur Halbierung der Lichtabsorption des Calciumspiegels als Lebensdauer bezeichnet. Durch die Methode werden dabei sowohl der Abbau der Fläche des Calciumspiegels vom Rand aus und durch punktuellen Abbau in der Fläche als auch die homogene Verringerung der Schichtdicke des Calciumspiegels durch vollflächigen Abbau erfasst.

Als Messbedingungen wurden 85 °C und 85 % relative Luftfeuchte gewählt. Die Muster wurden mit einer Schichtdicke der Haftklebemasse von 50 µm vollflächig und blasenfrei verklebt. Der Abbau des Ca-Spiegels wird über Transmissionsmessungen verfolgt. Die Durchbruchzeit (lag-time) ist definiert als diejenige Zeit, die Feuchtigkeit benötigt, um die Strecke bis zum Ca zurückzulegen.

Sofern nicht anders angegeben, sind alle Mengenangaben in den nachfolgenden Beispielen Gewichtsprozente beziehungsweise Gewichtsteile bezogen auf die Gesamtzusammensetzung.

### Beispiel 1

Als (Co-)polymer wurde ein Polystyrol-block-Polyisobutylen Blockcopolymer der Firma Kaneka ausgewählt. Es wurde Sibstar 103T (350 g) verwendet. Als Klebharz kam Escorez 5300 (Ring and Ball 105 °C, DACP = 71, MMAP = 72) der Firma ExxonMobile, ein vollhydriertes Kohlenwasserstoffharz (350 g) zum Einsatz. Als Reaktivharz wurde Uvacure 1500 der Firma Cytec ausgewählt, ein cycloaliphatisches Diepoxid (300 g). Diese Rohstoffe wurden in einem Gemisch aus Cyclohexan (950 g) und Aceton (50 g) gelöst, so dass eine 50 Gew.-% Lösung entsteht.

Anschließend wurde der Lösung ein latentreaktiver thermisch aktivierbarer Initiator zugesetzt. Hierzu wurden 3 g K-Pure TAG 2678 der Firma King Industries abgewogen. Die Initiatormenge wurde als 20 Gew.-%ige Lösung in Aceton angesetzt und dem oben genannten Gemisch zugesetzt.

Mittels eines Rakelverfahrens wurde die Formulierung aus Lösung auf einen silikonisierten PET-Liner beschichtet und bei 70 °C für 60 min getrocknet. Der Masseauftrag betrug 50 g/m². Das Muster wurde mit einer weiteren Lage eines silikonisierten aber leichter trennenden PET-Liners eingedeckt.

Die Aktivierungstemperatur dieser Muster nach Test J lag bei 94 °C. Die Aktivierungstemperatur dieser Muster nach Test K (in der Auslegung 70 °C Latenz) lag ebenfalls bei 94 °C, das normierte Integral lag nach Test K bei > 99 % bezogen auf das Integral aus Test J.

Aus diesen Mustern wurden Probekörper für Klebkraftmessungen erzeugt. Nach der Lamination der Musterstreifen wurde der Verbund für 1 h bei 100 °C getempert, so dass die Härtungsreaktion initiiert wurde. Die Klebkraft auf Glas (Floatglas) wurde nach Äquilibrierung bei 23 °C und 50 % rel. Luftfeuchtigkeit bestimmt und betrug 4,2 N/cm.

Weitere Muster wurden ohne vorherige Laminierung bei 100 °C für 1 h unter gleichen Bedingungen wie oben angegeben durch den PET-Liner gehärtet. Diese Muster wurden für WVTR- und OTR-Messungen (Mocon) verwendet und für die Ausprüfung optischer Eigenschaften.

Das Ergebnis aus der WVTR-Messung (Mocon) ergab 8 g/m^{2*}d und aus der OTR-Messung (Mocon) 830 cm³/m²*d*bar.

Die Untersuchung der optischen Eigenschaften der gehärteten Muster nach Ausdeckung beider PET-Liner ergab eine Transmission von 92 % und einen Haze von 1,4 %. Der Δb*-Wert lag bei 0,5.

### Beispiel 2

Als Copolymer wurde ein Polystyrol-block-Polyisobutylen Blockcopolymer der Firma Kaneka ausgewählt. Es wurde Sibstar 62M (375 g) verwendet. Als Klebharz kam Regalite R1100 (Ring and Ball 105 °C, DACP = 45, MMAP = 75) der Firma Eastman, ein vollhydriertes Kohlenwasserstoffharz (350 g) zum Einsatz. Als Reaktivharz wurde Uvacure 1500 der Firma Cytec ausgewählt, ein cycloaliphatisches Diepoxid (275 g). Diese Rohstoffe wurden in einem Gemisch aus Cyclohexan (300 g), Heptan (700 g) gelöst, so dass eine 50 Gew.-% Lösung entsteht.

Anschließend wurde der Lösung ein latentreaktiver thermisch aktivierbarer Initiator zugesetzt. Hierzu wurden 3 g K-Pure TAG 2678 der Firma King Industries abgewogen. Die Initiatormenge wurde als 20 Gew.-%ige Lösung in Aceton angesetzt und dem oben genannten Gemisch zugesetzt.

Mittels eines Rakelverfahrens wurde die Formulierung aus Lösung auf einen silikonisierten PET-Liner beschichtet und bei 70 °C für 60 min getrocknet. Der Masseauftrag betrug 50 g/m². Das Muster wurde mit einer weiteren Lage eines silikonisierten aber leichter trennenden PET-Liners eingedeckt.

Die Aktivierungstemperatur dieser Muster nach Test J lag bei 93 °C. Die Aktivierungstemperatur dieser Muster nach Test K (in der Auslegung 70 °C Latenz) lag bei 92 °C, das normierte Integral lag nach Test K bei > 99 % bezogen auf das Integral aus Test J.

Aus diesen Mustern wurden Probekörper für Klebkraftmessungen erzeugt. Nach der Lamination der Musterstreifen wurde der Verbund für 1 h bei 100 °C getempert, so dass die Härtungsreaktion initiiert wurde. Die Klebkraft auf Glas (Floatglas) wurde nach Äquilibrierung bei 23 °C und 50 % rel. Luftfeuchtigkeit bestimmt und betrug 5,9 N/cm. Weitere Muster wurden ohne vorherige Laminierung bei 100 °C für 1 h unter gleichen Bedingungen wie oben angegeben durch den PET-Liner gehärtet. Diese Muster wurden für WVTR- und OTR-Messungen (Mocon) verwendet und für die Ausprüfung optischer Eigenschaften.

Das Ergebnis aus der WVTR-Messung (Mocon) ergab 8 g/m^{2*}d und aus der OTR-Messung (Mocon) 780 cm³/m²*d*bar. Für diese Muster wurde zudem ein Lebensdauertest durchgeführt. Die Durchbruchzeit betrug 150 h. Dies ist überraschend (und auch überraschend gut im Vergleich zu UV-initiierten Systemen), da auf Grund der schneller ablaufenden Härtungsreaktion bei der erhöhten Temperatur eine Vorschädigung des empfindlichen (opto-)elektronischen Materials zu erwarten ist (zum Beispiel durch chemische Interaktion oder durch Auftreten innerer mechanischer Spannungen wie z. B. durch Härtungsschrumpf).

Die Untersuchung der optischen Eigenschaften der gehärteten Muster nach Ausdeckung beider PET-Liner ergab eine Transmission von 91 % und einen Haze von 1,7 %. Der Ab*-Wert lag bei 0,5.

### Beispiel 3

Als Copolymer wurde ein Polystyrol-block-Polyisobutylen-Blockcopolymer der Firma Kaneka ausgewählt. Es wurde Sibstar 73 T (300 g) verwendet. Als Klebharz kam Regalite R1100 (Ring and Ball 100°C, DACP = 45, MMAP = 75) der Firma Eastman, ein vollhydriertes Kohlenwasserstoffharz, mit 200 g zum Einsatz. Als Reaktivharz wurde Uvacure 1500 der Firma Cytec ausgewählt, und zwar zu 500 g. Diese Rohstoffe wurden in einem Gemisch aus Cyclohexan (950 g) und Aceton (50 g) gelöst, so dass eine 50 Gew.-%ige Lösung entsteht.

Anschließend wurde der Lösung ein latentreaktiver thermisch aktivierbarer Initiator zugesetzt. Hierzu wurden 2,5 g K-Pure CXC 1612 der Firma King Industries abgewogen. Der Initiator wurde als 20 Gew.-%ige Lösung in Aceton angesetzt und dem oben genannten Gemisch zugesetzt.

Mittels eines Rakelverfahrens wurde die Formulierung aus Lösung auf einen silikonisierten PET-Liner beschichtet und bei 60 °C für 60 min getrocknet. Der Masseauftrag betrug 50 g/m². Das Muster wurde mit einer weiteren Lage eines silikonisierten aber leichter trennenden PET-Liners eingedeckt.

Die Aktivierungstemperatur dieser Muster nach Test J lag bei 75 °C. Die Aktivierungstemperatur dieser Muster nach Test K (in der Auslegung 60 °C Latenz) lag bei 77 °C, das normierte Integral lag nach Test K bei 97 % bezogen auf das Integral aus Test J.

Aus diesen Mustern wurden Probekörper für Klebkraftmessungen erzeugt. Nach der Lamination der Musterstreifen wurde der Verbund für 1 h bei 80 °C getempert, so dass die Härtungsreaktion initiiert wurde. Die Klebkraft auf Glas (Floatglas) wurde nach Äquilibrierung bei 23 °C und 50 % rel. Luftfeuchtigkeit bestimmt und betrug 3,9 N/cm.

Weitere Muster wurden ohne vorherige Laminierung bei 80 °C für 1 h unter gleichen Bedingungen wie oben angegeben durch den PET-Liner gehärtet. Diese Muster wurden für WVTR- und OTR-Messungen (Mocon) verwendet und für die Ausprüfung optischer Eigenschaften.

Das Ergebnis aus der WVTR-Messung (Mocon) ergab 10 g/m^{2*}d und aus der OTR-Messung (Mocon) 860 cm³/m²*d*bar.

Die Untersuchung der optischen Eigenschaften der gehärteten Muster nach Ausdeckung beider PET-Liner ergab eine Transmission von 91 % und einen Haze von 1,5 %. Der Ab*-Wert lag bei 0,6.

## Patentansprüche

1. Eine Klebemasse, vorzugsweise Haftklebemasse umfassend
a) zumindest ein (Co-)polymer enthaltend zumindest Isobutylen und/oder Butylen als Comonomersorte und, optional aber bevorzugt, zumindest eine Comonomersorte, die - als hypothetisches Homopolymer betrachtet - eine Erweichungstemperatur von größer 40 °C aufweist,
b) zumindest eine Sorte eines zumindest teilhydrierten Klebharzes,
c) zumindest eine Sorte eines Reaktivharzes auf Basis eines cyclischen Ethers mit einer Erweichungstemperatur von kleiner 40 °C, bevorzugt von kleiner 20 °C,
(d) zumindest eine Sorte eines latentreaktiven thermisch aktivierbaren Initiators für die Initiierung einer kationischen Härtung,
**dadurch gekennzeichnet, dass** der Initiator eine Latenz gemäß Test K im Temperaturbereich unterhalb 60 °C und eine Aktivierungstemperatur gemäß Test J von höchstens 125 °C aufweist.

2. Klebemasse nach Anspruch 1,
**dadurch gekennzeichnet, dass**
das oder die (Co-)polymere Homopolymere oder statistische, alternierende, Block-, Stern- und/oder Pfropfcopolymere mit einer Molmasse M_{w} (Gewichtsmittel) von 1.000.000 g/mol oder kleiner, bevorzugt 500.000 g/mol oder kleiner sind.

3. Klebemasse nach Anspruch 1 oder 2,
**dadurch gekennzeichnet, dass**
als Homopolymer Polyisobutylen und/oder Polybutylen oder Gemische verschiedener Polyisobutylene und/oder Polybutylene verwendet werden.

4. Klebemasse nach zumindest einem der Ansprüche 1 bis 3,
**dadurch gekennzeichnet, dass**
als Copolymere statistische Copolymere aus mindestens zwei verschiedenen Monomersorten verwendet werden, von denen zumindest eine Isobutylen oder Butylen ist.

5. Klebemasse nach zumindest einem der vorhergehenden Ansprüche,
**dadurch gekennzeichnet, dass**
das oder die Copolymere Block-, Stern- und/oder Pfropfcopolymere sind, die zumindest eine Sorte eines ersten Polymerblocks ("Weichblock") mit einer Erweichungstemperatur von kleiner -20 °C und zumindest eine Sorte eines zweiten Polymerblocks ("Hartblock") mit einer Erweichungstemperatur von größer +40 °C aufweisen.

6. Klebemasse nach zumindest einem der vorhergehenden Ansprüche,
**dadurch gekennzeichnet, dass**
als teilhydrierte Klebharze solche eingesetzt werden, die mit dem Copolymer beziehungsweise, sofern ein aus Hart- und Weichblöcken aufgebautes Copolymer eingesetzt wird, hauptsächlich mit dem Weichblock verträglich sind.

7. Klebemasse nach zumindest einem der vorhergehenden Ansprüche,
**dadurch gekennzeichnet, dass**
die teilhydrierten Klebharze eine Klebharzerweichungstemperatur von größer 25 °C, bevorzugt größer 80 °C aufweisen.

8. Klebemasse nach zumindest einem der vorhergehenden Ansprüche,
**dadurch gekennzeichnet, dass**
die Klebemasse zumindest ein Klebharz enthält, das ein unpolares Harz mit einem DACP-Wert (diacetone alcohol cloud point) oberhalb von 30 °C und mit einem MMAP-Wert (mixed methylcylohexane aniline point) von größer 50 °C ist.

9. Klebemasse nach zumindest einem der vorhergehenden Ansprüche,
**dadurch gekennzeichnet, dass**
der Anteil an Klebharz(en) in der Klebemasserezeptur bei mindestens 20 Gew.-% und höchstens 60 Gew.-%, bevorzugt bei mindestens 30 Gew.-% und höchstens 40 Gew.-% liegt.

10. Klebemasse nach zumindest einem der vorhergehenden Ansprüche,
**dadurch gekennzeichnet, dass**
die Klebemasse zumindest eine Sorte eines Reaktivharzes auf Basis eines cyclischen Ethers für die thermische Vernetzung mit einer Erweichungstemperatur im ungehärteten Zustand von kleiner 40 °C, bevorzugt von kleiner 20 °C enthält.

11. Klebemasse nach zumindest einem der vorhergehenden Ansprüche,
**dadurch gekennzeichnet, dass**
die Aktivierungstemperatur der latentreaktiven thermischen Initiatoren bei höchstens 100 °C liegt.

12. Klebemasse nach zumindest einem der vorhergehenden Ansprüche,
**dadurch gekennzeichnet, dass**
die thermisch aktivierbaren Initiatoren gewählt werden aus der Gruppe Pyridinium-, Ammonium- (insbesondere Anilinium-) und Sulfonium- (insbesondere Thiolanium-)-Salze sowie Lanthanoidtriflate.

13. Klebemasse nach zumindest einem der Ansprüche 1 bis 11,
**dadurch gekennzeichnet, dass**
die thermisch aktivierbaren Initiatoren gewählt werden aus der Gruppe Lanthanoidtriflate.

14. Klebemasse nach zumindest einem der vorhergehenden Ansprüche,
**dadurch gekennzeichnet, dass**
der Anteil thermisch aktivierbarer Initiatoren in Bezug auf die Reaktivharzeinsatzmenge bei mindestens 0,3 Gew.-% und höchstens 2,5 Gew.-%, bevorzugt bei mindestens 0,5 Gew.-% und höchstens 1,5 Gew.-% liegt.

15. Klebemasse nach zumindest einem der vorhergehenden Ansprüche,
**dadurch gekennzeichnet, dass**
die Haftklebemasse ein oder mehrere Additive enthält,
vorzugsweise ausgewählt aus der Gruppe bestehend aus Plastifizierungsmitteln, primären Antioxidantien, sekundären Antioxidantien, Prozessstabilisatoren, Lichtschutzmitteln, Verarbeitungshilfsmittel, Endblockverstärkerharzen, Polymeren, insbesondere elastomerer Natur.

16. Klebemasse nach zumindest einem der vorhergehenden Ansprüche,
**dadurch gekennzeichnet, dass**
die Haftklebemasse einen oder mehrere Füllstoffe enthält,
vorzugsweise nanoskalige Füllstoffe, transparente Füllstoffe und/oder Getter-und/oder Scavenger-Füllstoffe

17. Klebemasse nach zumindest einem der vorhergehenden Ansprüche,
**dadurch gekennzeichnet, dass**
die Klebemasse im sichtbaren Licht des Spektrums (Wellenlängenbereich von etwa 400 nm bis 800 nm) transparent ist.

18. Klebemasse nach zumindest einem der vorhergehenden Ansprüche,
**dadurch gekennzeichnet, dass**
die Klebemasse einen Haze gemäß Test F kleiner 5,0 %, bevorzugt kleiner 2,5 % zeigt.

19. Klebemasse nach zumindest einem der vorhergehenden Ansprüche,
**dadurch gekennzeichnet, dass**
der Initiator eine Latenz im Temperaturbereich unterhalb 70 °C aufweist.

20. Klebeband enthaltend zumindest eine Schicht einer Klebemasse nach zumindest einem der vorangehenden Ansprüche und einen Träger,
**dadurch gekennzeichnet, dass**
der Träger eine Permeationsbarriere von WVTR < 0,1 g/(m² d) und OTR < 0,1 cm³/(m² d bar) aufweist.

21. Klebeband nach Anspruch 20,
**dadurch gekennzeichnet, dass**
der Träger eine beschichtete Kunststofffolie ist.

22. Klebeband nach Anspruch 20,
**dadurch gekennzeichnet, dass**
der Träger eine Schicht eines flexiblen Dünnglases mit einer Schichtdicke von höchstens 1 mm, bevorzugt höchstens 100 µm aufweist, vorzugsweise der Träger aus einer Schicht eines Dünnglases mit einer Schichtdicke von höchstens 1 mm besteht, wobei weiter vorzugsweise das Dünnglas ein Borosilikatglas oder ein alkalifreies Aluminoborosilikatglas ist.

23. Klebeband nach Anspruch 22,
**dadurch gekennzeichnet, dass**
das Dünnglas in bandförmiger Geometrie vorliegt.

24. Verwendung einer Klebemasse oder eines mit der Klebemasse gebildeten ein- oder doppelseitig klebenden Klebebands nach zumindest einem der vorhergehenden Ansprüche zur Kapselung einer (opto-)elektronischen Anordnung.

25. Verwendung nach Anspruch 24,
**dadurch gekennzeichnet, dass**
die Haftklebemasse und/oder die zu kapselnden Bereiche der elektronischen Anordnung vor, während und/oder nach der Applikation der Haftklebemasse erwärmt werden.

26. Verwendung nach Anspruch 24 oder 25,
**dadurch gekennzeichnet, dass**
die Haftklebemasse nach der Applikation auf der elektronischen Anordnung teil- oder endvernetzt wird.

27. Elektronische Anordnung mit einer elektronischen Struktur, insbesondere einer organischen elektronischen Struktur, und einer Haftklebmasse,
wobei die elektronische Struktur zumindest teilweise durch die Haftklebmasse gekapselt ist,
**dadurch gekennzeichnet,**
**dass** die Haftklebmasse gemäß zumindest einem der vorherigen Ansprüche ausgebildet ist.

## Claims

1. An adhesive, preferably pressure-sensitive adhesive, comprising
a) at least one (co)polymer comprising at least isobutylene and/or butylene as comonomer kind and, optionally but preferably, at least one comonomer kind which - considered as hypothetical homopolymer - has a softening temperature of greater than 40°C,
b) at least one kind of an at least partly hydrogenated tackifier resin,
c) at least one kind of a reactive resin based on a cyclic ether having a softening temperature of less than 40°C, preferably less than 20°C,
(d) at least one kind of a latent-reactive thermally activatable initiator for initiating cationic curing, **characterized in that** the initiator has a latency according to Test K in the temperature range below 60°C and an activation temperature according to Test J of at most 125°C.

2. Adhesive according to Claim 1,
**characterized in that**
the (co)polymer or (co)polymers is or are homopolymers or random, alternating, block, star and/or graft copolymers having a molar mass M_{w} (weight average) of 1 000 000 g/mol or less, preferably 500 000 g/mol or less.

3. Adhesive according to Claim 1 or 2,
**characterized in that**
as homopolymer use is made of polyisobutylene and/or polybutylene or mixtures of different polyisobutylenes and/or polybutylenes.

4. Adhesive according to at least one of Claims 1 to 3,
**characterized in that**
as copolymers use is made of random copolymers of at least two different kinds of monomer, of which at least one is isobutylene or butylene.

5. Adhesive according to at least one of the preceding claims,
**characterized in that**
the copolymer or copolymers is or are block, star and/or graft copolymers which contain at least one kind of a first polymer block ("soft block") having a softening temperature of less than -20°C and at least one kind of a second polymer block ("hard block") having a softening temperature of greater than +40°C.

6. Adhesive according to at least one of the preceding claims,
**characterized in that**
as partly hydrogenated tackifier resins use is made of resins which are compatible with the copolymer and/or, where a copolymer constructed from hard blocks and soft blocks is used, are compatible primarily with the soft block.

7. Adhesive according to at least one of the preceding claims,
**characterized in that**
the partly hydrogenated tackifier resins have a tackifier resin softening temperature of greater than 25°C, preferably greater than 80°C.

8. Adhesive according to at least one of the preceding claims,
**characterized in that**
the adhesive comprises at least one tackifier resin which is an apolar resin having a DACP (diacetone alcohol cloud point) of above 30°C and having a MMAP (mixed methylcyclohexane aniline point) of greater than 50°C.

9. Adhesive according to at least one of the preceding claims,
**characterized in that**
the fraction of tackifier resin(s) in the adhesive formula is at least 20 wt% and at most 60 wt%, preferably at least 30 wt% and at most 40 wt%.

10. Adhesive according to at least one of the preceding claims,
**characterized in that**
the adhesive comprises at least one kind of a reactive resin based on a cyclic ether for the thermal crosslinking with a softening temperature in the uncured state of less than 40°C, preferably of less than 20°C.

11. Adhesive according to at least one of the preceding claims,
**characterized in that**
the activation temperature of the latent-reactive thermal initiators is at most 100°C.

12. Adhesive according to at least one of the preceding claims,
**characterized in that**
the thermally activatable initiators are selected from the group of pyridinium salts, ammonium salts (especially anilinium salts) and sulphonium salts (especially thiolanium) salts and also lanthanoid triflates.

13. Adhesive according to at least one of Claims 1 to 11,
**characterized in that**
the thermally activatable initiators are selected from the group of lanthanoid triflates.

14. Adhesive according to at least one of the preceding claims,
**characterized in that**
the fraction of thermally activatable initiators in relation to the amount of reactive resin used is at least 0.3 wt% and at most 2.5 wt%, preferably at least 0.5 wt% and at most 1.5 wt%.

15. Adhesive according to at least one of the preceding claims,
**characterized in that**
the pressure-sensitive adhesive comprises one or more additives,
preferably selected from the group consisting of plasticizers, primary antioxidants, secondary antioxidants, process stabilizers, light stabilizers, processing assistants, endblock reinforcer resins, polymers, more particularly elastomeric in nature.

16. Adhesive according to at least one of the preceding claims,
**characterized in that**
the pressure-sensitive adhesive comprises one or more fillers,
preferably nanoscale fillers, transparent fillers and/or getter and/or scavenger fillers.

17. Adhesive according to at least one of the preceding claims,
**characterized in that**
the adhesive is transparent in the visible light of the spectrum (wavelength range from about 400 nm to 800 nm).

18. Adhesive according to at least one of the preceding claims,
**characterized in that**
the adhesive exhibits a haze according to Test F of less than 5.0%, preferably less than 2.5%.

19. Adhesive according to at least one of the preceding claims,
**characterized in that**
the initiator has a latency in the temperature range below 70°C.

20. Adhesive tape comprising at least one layer of an adhesive according to at least one of the preceding claims and a carrier,
**characterized in that**
the carrier has a permeation barrier of WVTR < 0.1 g/ (m² d) and OTR < 0.1 cm³/ (m² d bar).

21. Adhesive tape according to Claim 20,
**characterized in that**
the carrier is a coated polymeric film.

22. Adhesive tape according to Claim 20,
**characterized in that**
the carrier has a layer of a flexible thin glass with a layer thickness of not more than 1 mm, preferably not more than 100 µm, the carrier preferably consisting of a layer of a thin glass with a layer thickness of not more than 1 mm, and with further preference the thin glass is a borosilicate glass or an alkali-free aluminoborosilicate glass.

23. Adhesive tape according to Claim 22,
**characterized in that**
the thin glass is present in tape-like geometry.

24. Use of an adhesive or of a single-sided or double-sided adhesive tape formed with the adhesive according to at least one of the preceding claims for encapsulating an (opto)electronic arrangement.

25. Use according to Claim 24,
**characterized in that**
the pressure-sensitive adhesive and/or the regions of the electronic arrangement that are to be encapsulated are heated before, during and/or after the application of the pressure-sensitive adhesive.

26. Use according to Claim 24 or 25,
**characterized in that**
the pressure-sensitive adhesive is cured partly or to completion on the electronic arrangement after application.

27. Electronic arrangement having an electronic structure, more particularly an organic electronic structure, and a pressure-sensitive adhesive,
the electronic structure being at least partly encapsulated by the pressure-sensitive adhesive, **characterized**
**in that** the pressure-sensitive adhesive is designed according to at least one of the preceding claims.

## Revendications

1. Substance adhésive, de préférence une substance auto-adhésive comprenant
a) au moins un (co-)polymère contenant au moins de l'isobutylène et/ou du butylène comme type de comonomère et, éventuellement mais de préférence, au moins un type de comonomère qui présente, en tant que homopolymère hypothétique, une température de ramollissement supérieure à 40 °C,
b) au moins un type de résine adhésive au moins partiellement hydrogénée,
c) au moins un type de résine réactive à base d'un éther cyclique présentant une température de ramollissement inférieure à 40 °C, de préférence inférieure à 20 °C,
d) au moins un type d'amorceur réactif latent activable thermiquement destiné à amorcer un durcissement cationique,
**caractérisée en ce que** l'amorceur présente une latence selon le test K dans la plage de températures inférieure à 60 °C et une température d'activation selon le test J d'au plus 125 °C.

2. Substance adhésive selon la revendication 1,
**caractérisée en ce que**
le ou les (co-)polymères sont des homopolymères ou des copolymères statistiques, alternés, séquencés, en étoile et/ou greffés présentant une masse molaire M_{w} (poids moyen) de 1000000 g/mol ou moins, de préférence 500000 g/mol ou moins.

3. Substance adhésive selon la revendication 1 ou 2,
**caractérisée en ce que**
du polyisobutylène et/ou du polybutylène ou des mélanges de différents polyisobutylènes et/ou polybutylènes peuvent être utilisés comme homopolymère.

4. Substance adhésive selon l'une au moins des revendications 1 à 3,
**caractérisée en ce que**
des copolymères statistiques d'au moins deux types différents de monomères, dont l'un au moins est l'isobutylène ou le butylène, sont utilisés comme copolymères.

5. Substance adhésive selon l'une au moins des revendications précédentes,
**caractérisée en ce que**
le ou les copolymères sont des copolymères séquencés, en étoile et/ou greffés, qui comportent au moins un type d'un premier bloc polymère (« bloc mou ») présentant une température de ramollissement inférieure à -20 °C et au moins un type d'un deuxième bloc polymère (« bloc dur ») présentant une température de ramollissement supérieure à +40 °C.

6. Substance adhésive selon l'une au moins des revendications précédentes,
**caractérisée en ce que**
les résines adhésives partiellement hydrogénées utilisées sont celles qui sont compatibles avec le copolymère ou, dans la mesure où un copolymère comprenant des blocs durs et mous est utilisé, celles qui sont compatibles principalement avec le bloc mou.

7. Substance adhésive selon l'une au moins des revendications précédentes,
**caractérisée en ce que**
les résines adhésives partiellement hydrogénées présentent une température de ramollissement de résine adhésive supérieure à 25 °C, de préférence supérieure à 80 °C.

8. Substance adhésive selon l'une au moins des revendications précédentes,
**caractérisée en ce que**
la substance adhésive contient au moins une résine adhésive qui est une résine non polaire ayant une valeur DACP (diactone alcohol cloud point - point de trouble de diacétone alcool) supérieure à 30 °C et une valeur MMAP (mixed methylcyclohexane aniline point - point mixte de méthylcyclohexane aniline) supérieure à 50 °C.

9. Substance adhésive selon l'une au moins des revendications précédentes,
**caractérisée en ce que**
la proportion de résine(s) adhésive(s) dans la formulation de substance adhésive est d'au moins 20 % en poids et d'au plus 60 % en poids, de préférence d'au moins 30 % en poids et d'au plus 40 % en poids.

10. Substance adhésive selon l'une au moins des revendications précédentes,
**caractérisée en ce que**
la substance adhésive contient au moins un type de résine réactive à base d'un éther cyclique destiné à la réticulation thermique à une température de ramollissement à l'état mou inférieure à 40 °C, de préférence inférieure à 20 °C.

11. Substance adhésive selon l'une au moins des revendications précédentes,
**caractérisée en ce que**
la température d'activation des amorceurs thermiques réactifs latents est d'au plus 100 °C.

12. Substance adhésive selon l'une au moins des revendications précédentes,
**caractérisée en ce que**
les amorceurs activables thermiquement sont choisis dans le groupe comprenant les sels de pyridinium, d'ammonium (en particulier d'anilinium) et de sulfonium (en particulier de thiolanium) et les triflates de lanthanide.

13. Substance adhésive selon l'une au moins des revendications 1 à 11,
**caractérisée en ce que**
les amorceurs activés thermiquement sont choisis dans le groupe des triflates de lanthanide.

14. Substance adhésive selon l'une au moins des revendications précédentes,
**caractérisée en ce que**
la proportion d'amorceurs activables thermiquement par rapport à la quantité de résine réactive utilisée est d'au moins 0,3 % en poids et d'au plus 2,5 % en poids, de préférence d'au moins 0,5 % en poids et d'au plus 1,5 % en poids.

15. Substance adhésive selon l'une au moins des revendications précédentes,
**caractérisée en ce que**
la substance auto-adhésive contient un ou plusieurs additifs, de préférence choisis dans le groupe comprenant les plastifiants, les antioxydants primaires, les antioxydants secondaires, les stabilisants de processus, les photo-stabilisants, les auxiliaires de traitement, les résines de renforcement de blocs terminaux, les polymères, en particulier de nature élastomère.

16. Substance adhésive selon l'une au moins des revendications précédentes,
**caractérisée en ce que**
la substance auto-adhésive contient une ou plusieurs charges, de préférence des charges nanométriques, des charges transparentes et/ou des charges à sorption et/ou adsorbantes.

17. Substance adhésive selon l'une au moins des revendications précédentes,
**caractérisée en ce que**
la substance adhésive est transparente à la lumière visible du spectre (plage de longueurs d'onde d'environ 400 nm à 800 nm).

18. Substance adhésive selon l'une au moins des revendications précédentes,
**caractérisée en ce que**
la substance adhésive présente un trouble selon le test F inférieur à 5,0 %, de préférence inférieur à 2,5 %.

19. Substance adhésive selon l'une au moins des revendications précédentes,
**caractérisée en ce que**
l'amorceur présente une latence dans la plage de températures inférieure à 70 °C.

20. Bande adhésive comprenant au moins une couche d'une substance adhésive selon l'une au moins des revendications précédentes et un support,
**caractérisée en ce que**
le support comporte une barrière de perméation de WVTR < 0,1 g/ (m²d) et d'OTR < 0,1 cm³/(m²d bar).

21. Bande adhésive selon la revendication 20,
**caractérisée en ce que**
le support est un film de matière synthétique pourvu d'un revêtement.

22. Bande adhésive selon la revendication 20,
**caractérisée en ce que**
le support comporte une couche de verre mince flexible ayant une épaisseur de couche d'au plus 1 mm, de préférence d'au plus 100 µm, de préférence le support est une couche de verre mince ayant une épaisseur de couche d'au plus 1 mm, plus préférablement le verre mince étant un verre au borosilicate ou un verre à l'aluminoborosilicate exempt d'alcali.

23. Bande adhésive selon la revendication 22,
**caractérisée en ce que**
le verre mince est présent dans une géométrie en forme de bande.

24. Utilisation d'une substance adhésive ou d'une bande adhésive simple ou double face formée avec la substance adhésive selon l'une au moins des revendications précédentes pour encapsuler un dispositif (opto-)électronique.

25. Utilisation selon la revendication 24,
**caractérisée en ce que**
la substance auto-adhésive et/ou les zones du dispositif électronique à encapsuler sont chauffées avant, pendant et/ou après l'application de la substance auto-adhésive.

26. Utilisation selon la revendication 24 ou 25,
**caractérisée en ce que**
la substance auto-adhésive est soumise à une réticulation partielle ou finale après application sur le dispositif électronique.

27. Dispositif électronique comprenant une structure électronique, en particulier une structure électronique organique, et une substance auto-adhésive, la structure électronique étant au moins partiellement encapsulée par la substance auto-adhésive,
**caractérisé en ce que**,
la substance auto-adhésive est conçue selon l'une au moins des revendications précédentes.
